(19) **Europäisches Patentamt / European Patent Office / Office européen des brevets**

(11) **EP 4 479 967 B1**

(12) **FASCICULE DE BREVET EUROPEEN**

(45) Date de publication et mention de la délivrance du brevet:
**10.06.2026 Bulletin 2026/24**

(21) Numéro de dépôt: **23703793.2**

(22) Date de dépôt: **13.02.2023**

(51) Classification Internationale des Brevets (IPC):
**G10L 19/008** (2013.01)   **H03M 7/30** (2006.01)
**H04N 19/94** (2014.01)   **G10L 19/00** (2013.01)

(52) Classification Coopérative des Brevets (CPC):
**G10L 19/008; H03M 7/3082; H04N 19/94;**
G10L 2019/0004

(86) Numéro de dépôt international:
**PCT/EP2023/053413**

(87) Numéro de publication internationale:
**WO 2023/152348 (17.08.2023 Gazette 2023/33)**

(54) **CODAGE DE COORDONNÉES SPHÉRIQUES UTILISANT UN DICTIONNAIRE DE QUANTIFICATION SPHÉRIQUE OPTIMISÉ**

CODIERUNG VON SPHÄRISCHEN KOORDINATEN UNTER VERWENDUNG EINES OPTIMIERTEN SPHÄRISCHEN QUANTISIERUNGSWÖRTERBUCHS

CODING OF SPHERICAL COORDINATES USING AN OPTIMIZED SPHERICAL QUANTIZATION DICTIONARY

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **14.02.2022 FR 2201286**

(43) Date de publication de la demande:
**25.12.2024 Bulletin 2024/52**

(60) Demande divisionnaire:
**26166379.3 / 4 738 834**

(73) Titulaire: **Orange**
**92130 Issy-les-Moulineaux (FR)**

(72) Inventeurs:
• **RAGOT, Stéphane**
  **92326 Châtillon cedex (FR)**
• **YAOUMI, Mohamed**
  **92326 Châtillon cedex (FR)**

• **MATSCHKAL B ET AL:** "Spherical Logarithmic Quantization", IEEE TRANSACTIONS ON AUDIO, SPEECH AND LANGUAGE PROCESSING, IEEE, US, vol. 18, no. 1, 2 June 2009 (2009-06-02), pages 126 - 140, XP011329117, ISSN: 1558-7916, DOI: 10.1109/TASL.2009.2024383
• **NOKIA CORPORATION:** "Description of the IVAS MASA C Reference Software", vol. SA WG4, no. Busan, Republic of Korea; 20191021 - 20191025, 15 October 2019 (2019-10-15), XP051799447, Retrieved from the Internet <URL:https://ftp.3gpp.org/tsg_sa/WG4_CODEC/TSGS4_106_Busan/Docs/S4-191167.zip> [retrieved on 20191015]
• **BIN CHENG ET AL:** "A General Compression Approach to Multi-Channel Three-Dimensional Audio", IEEE TRANSACTIONS ON AUDIO, SPEECH AND LANGUAGE PROCESSING, IEEE, US, vol. 21, no. 8, 25 April 2013 (2013-04-25), pages 1676 - 1688, XP011519776, ISSN: 1558-7916, DOI: 10.1109/TASL.2013.2260156

(56) Documents cités:
WO-A1-2020/016479   WO-A1-2021/019126
US-A1- 2020 265 851

**Description**

La présente invention concerne la quantification vectorielle sphérique appliquée au codage/décodage de données sonores, pour le codage de directions d'arrivée de source (abrégées comme « DoA » pour Direction of Arrival en anglais) qui sont en général représentées par des coordonnées sphériques (par exemple azimut et élévation, à une distance pré-déterminée).

Les codeurs/décodeurs (ci-après appelés « codecs ») qui sont utilisés actuellement en téléphonie mobile sont mono (un seul canal de signal pour une restitution sur un seul haut-parleur). Le codec 3GPP EVS (pour « Enhanced Voice Services ») permet d'offrir une qualité « Super-HD » (aussi appelée voix « Haute Définition Plus » ou HD+) avec une bande audio en bande super-élargie (SWB pour « super-wideband » en anglais) pour des signaux échantillonnés à 32 ou 48 kHz ou pleine bande (FB pour « Fullband ») pour des signaux échantillonnés à 48 kHz ; la largeur de bande audio est de 14,4 à 16 kHz en mode SWB (de 9,6 à 128 kbit/s) et de 20 kHz en mode FB (de 16,4 à 128 kbit/s).

La prochaine évolution de qualité dans les services conversationnels proposés par les opérateurs devrait être constituée par les services immersifs, en utilisant des terminaux tels que des smartphones équipés de plusieurs microphones ou des équipements de conférence audio spatialisée ou de visioconférence de type télé-présence ou vidéo 360°, ou encore des équipements de partage de contenus audio « live », avec un rendu sonore spatialisé en 3D autrement plus immersif qu'une simple restitution stéréo 2D. Avec les usages de plus en plus répandus d'écoute sur téléphone mobile avec un casque audio et l'apparition d'équipements audio avancés (accessoires tels qu'un microphone 3D, assistants vocaux avec antennes acoustiques, casques de réalité virtuelle ou augmentée, etc.) la captation et le rendu de scènes sonores spatialisées sont désormais assez répandus pour offrir une expérience de communication immersive.

A ce titre, la future norme 3GPP « IVAS » (pour « Immersive Voice And Audio Services ») propose l'extension du codec EVS à l'audio immersif en acceptant comme format d'entrée du codec au moins les formats de son spatialisé listés ci-dessous (et leurs combinaisons) :

- Format multicanal (channel-based en anglais) de type stéréo ou 5.1 où chaque canal vient alimenter un haut-parleur (par exemple L et R en stéréo ou L, R, Ls, Rs et C en 5.1) ;
- Format objet (object-based en anglais) où des objets sonores sont décrits comme un signal audio (en général mono) associé à des métadonnées décrivant les attributs de cet objet (position dans l'espace, largeur spatiale de la source, etc.),
- Format ambisonique (scene-based en anglais) qui décrit le champ sonore en un point donné, en général capté par un microphone sphérique ou synthétisé dans le domaine des harmoniques sphériques.

Il est également question de considérer potentiellement d'autres formats d'entrée tels que le format appelé MASA (Metadata assisted Spatial Audio en anglais) qui correspond à une représentation paramétrique d'une prise de son sur téléphone mobile équipés de plusieurs microphones. Ce format est étudié plus en détails ci-après.

ATSCHKAL B ET AL: "Spherical Logarithmic Quantization",IEEE TRANSACTIONS ON AUDIO, SPEECH AND LANGUAGE PROCESSING, 2 juin 2009, divulgue une quantification logarithmique sphérique combinée à l'ADPCM. Ce document décrit la méthode pour découper une sphère en zones de quantification équivalentes. WO 2021/019126 A1 et WO 2020/016479 A1 décrivent la quantification scalaire des paramètres d'élévation et d'azimut en tant que métadonnées spatiales dans le contexte du codec IVAS. L'élévation et l'azimut sont quantifiés selon une grille sphérique sur une sphère unitaire.

Les signaux à traiter par le codeur/décodeur se présentent comme des successions de blocs d'échantillons sonores appelés « trames » ou « sous-trames » ci-après.

En outre, ci-après, les notations mathématiques suivent la convention suivante :

- Scalaire : *s* ou N (minuscule pour les variables ou majuscule pour les constantes)
- Vecteur : *q* (minuscule, gras et italique)
- Matrice : *M* (majuscule, gras et italique)

Par la suite, on notera la sphère $\mathbb{S}_n$ de rayon r en dimension n+1 définie comme

$$\mathbb{S}_n = \left\{ \boldsymbol{x} = (x_1, \ldots, x_{n+1}) \in \mathbb{R}^{n+1} \mid \|\boldsymbol{x}\| = \sqrt{x_1{}^2 + \cdots + x_{n+1}{}^2} = r \right\}$$

où ||. || désigne la norme euclidienne. Quand le rayon r ne sera pas précisé, on supposera que r = 1 (sphère unité). On se focalise ici sur le cas de la dimension 3 où n=2.

On rappelle ici la définition des coordonnées sphériques en dimension 3. Pour un point *(x, y, z)* en dimension 3 on a en général au moins deux conventions classiques de coordonnées sphériques notées $(r, \phi, \theta)$:

- la convention géographique : *x* = r cos $\phi$ cos $\theta$, *y* = r cos $\phi$ sin $\theta$, **z** = r sin $\phi$ avec $r \geq 0$, -π/2 $\leq \phi \leq$ π/2 et -π $\leq \theta \leq$ π
- la convention physique : *x* = *r* sin $\phi$ cos $\theta$, *y* = *r* sin $\phi$ sin $\theta$, **z** = *r* cos $\phi$ avec $r \geq 0$, 0 $\leq \phi \leq$ π et -π $\leq \theta \leq$ π

Les angles $\phi$, $\theta$ sont ici définis en radians, sans perte de généralité.

Le rayon *r* et l'azimut (ou longitude) $\theta$ sont identiques dans ces deux définitions, mais l'angle $\phi$ diffère selon qu'il est défini par rapport au plan horizontal 0xy (élévation ou latitude sur l'intervalle [-π/2, π/2]) ou à partir de l'axe 0z (co-latitude ou angle polaire sur l'intervalle [0, π]). L'azimut $\theta$ peut être défini sur un intervalle [-π,π] de façon équivalente on pourra le définir sur [0,2π] par simple opération de modulo 2π. Par la suite, on représentera de façon préférentielle les mêmes coordonnées angulaires en degrés, mais d'autres unités pourront être utilisées. On notera que les symboles peuvent être différents dans la littérature (par exemple $\varphi$ au lieu de $\phi$) et/ou intervertis (par exemple $\theta$ pour la colatitude et $\varphi$ pour la la longitude).

Par la suite, la convention adoptée sera préférentiellement d'utiliser la paire élévation et azimut, mais l'invention s'applique à toutes les variantes de définition de coordonnées sphériques.

On s'intéresse dans l'invention à des exemples de réalisation de quantification vectorielle sphérique appliqués au codage de directions 3D de sources audio. L'invention pourra également s'appliquer à d'autres formats audios et à d'autres signaux (par exemple des images ou vidéo 360) dans lesquels des données sphériques en dimension 3 sont à coder.

On rappelle ci-dessous les principes du codage DiRAC (pour Directional Audio Coding en anglais). Dans des variantes, on pourra appliquer l'invention à d'autres schémas de codage, en particulier pour le codage audio par transformée.

Le codage DiRAC est décrit par exemple dans l'article V. Pulkki, Spatial sound reproduction with directional audio coding, Journal of the Audio Engineering Society, vol. 55, no. 6, pp. 503-516, 2007. Dans ce document, une cartographie est réalisée par le biais d'une analyse directionnelle pour trouver une direction (DoA) par sous-bandes. Cette DoA est complétée par un paramètre de « diffuseness », ce qui donne une description paramétrique de la scène sonore.

Le signal d'entrée multicanal est codé sous la forme de canaux de transport (typiquement un signal mono ou stéréo obtenu par réduction de multiples canaux captés) et des métadonnées spatiales (DoA et « diffuseness » par sous-bandes).

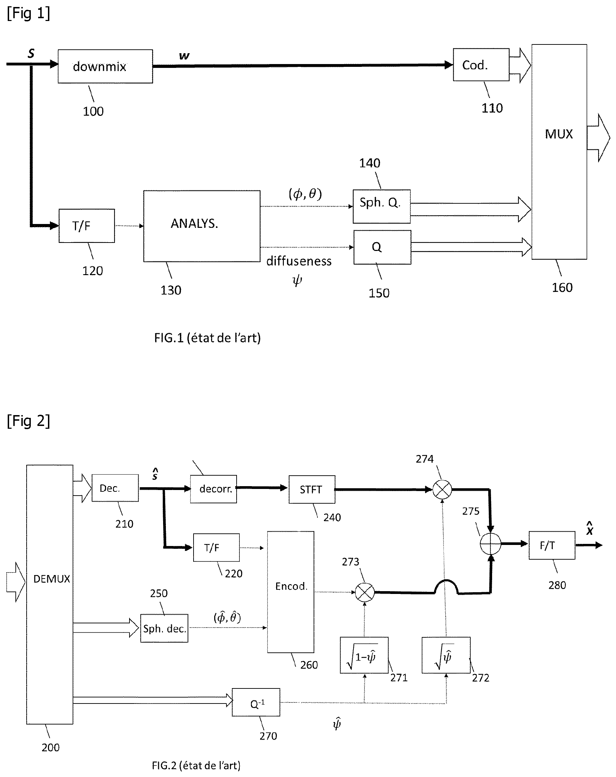

On décrit à la **figure 1** un exemple de mise en œuvre du codage DirAC. Dans cet exemple, le codage utilise une réduction du nombre de canaux (downmix en anglais - bloc 100), où on ne code (bloc 110) par exemple qu'un seul canal avec un codec mono - par exemple 3GPP EVS à un débit donné (24.4 kbit/s). Le signal d'entrée est également décomposé (bloc 120) en sous-bandes fréquentielles par exemple par un banc de filtres ou par une transformée de Fourier à court-terme. On suppose ici une découpe en bandes de Bark, par exemple 24 sous-bandes réparties en fréquences selon l'échelle Bark connues de l'état de l'art. Dans chaque trame et chaque sous-bande le codage DiRAC estime typiquement deux paramètres (bloc 130) - pour alléger les notations on n'utilise pas d'indice de trame ni de sous-bandes pour les différents paramètres: la direction de la source dominante (DoA) en termes d'élévation ($\phi$) et d'azimut ($\theta$), et la « diffuseness » $\psi$ comme décrit dans l'article précité de Pulkki. L'estimation de la DoA s'effectue en général par le biais d'un vecteur intensité active avec une moyenne temporelle, dans des variantes on pourra mettre en œuvre d'autres méthodes d'estimation de $\phi$, $\theta$, $\psi$.

La DoA est codée (bloc 140) sur un nombre prédéterminé de bits (par exemple 7 bits) par paire ($\phi$, $\theta$) dans chaque trame et chaque sous-bande. La « diffuseness » $\psi$ est un paramètre compris entre 0 et 1, elle est ici codée (bloc 150) par quantification scalaire (par exemple sur 6 bits). Dans l'exemple donné, le budget de codage des métadonnées spatiales est donc 24 x (7+6)=312 bits par trame, soit 15.6 kbit/s, pour un budget global de 24.4+15.6 = 40 kbit/s. Le train binaire du codage du signal « downmix » et les paramètres spatiaux codés sont multiplexés (bloc 160) pour former le train binaire de chaque trame.

La **figure 2** illustre un exemple de réalisation d'un décodeur DirAC. Après démultiplexage du train binaire (bloc 200), on décode le signal « downmix » (bloc 210). Les paramètres spatiaux sont décodés (bloc 250 et bloc 270). Le signal décodé $\hat{s}$ est ensuite décomposé en temps/fréquences (bloc 220 identique au bloc 120) pour le spatialiser comme une source ponctuelle (onde plane) dans le bloc (bloc 260) qui génère un signal ambisonique d'ordre 1 spatialisé comme:

$$X(\hat{\phi}, \hat{\theta}) = \begin{bmatrix} 1 \\ \cos\hat{\phi}\cos\hat{\theta} \\ \cos\hat{\phi}\sin\hat{\theta} \\ \sin\hat{\phi} \end{bmatrix} \cdot \hat{s}$$

A partir du signal décodé on effectue une décorrélation (bloc 230) pour avoir une version « diffuse » (correspondant à une largeur de source maximale) ; cette décorrélation réalise également une augmentation du nombre de canaux pour obtenir en sortie du bloc 230 un signal ambisonique d'ordre 1 avec 4 canaux (W, Y, Z, X). Le signal décorrélé est décomposé en temps/fréquences (bloc 240). Les signaux issus des blocs 240 et 260 sont combinés (bloc 275) par sous-bande, après application d'un facteur d'échelle (blocs 273 et 274) obtenus à partir de la « diffuseness » décodée (blocs 271 et 272) ; ce mélange adaptatif permet de « doser » la largeur de source et le caractère diffus du champ sonore dans chaque sous-bande. Le signal mélangé est converti en temporel (bloc 280) par banc de filtres ou une transformée court-terme inverse.

Les directions de sources dans le format DirAC sont donc représentées sous la forme de données sphériques 3D, typiquement sous la forme de coordonnées sphériques (azimut, élévation) selon la convention géographique. Il existe dans ce contexte un besoin de représenter ces informations de DoA de façon efficace, ce qui peut se formuler comme un problème de quantification vectorielle sur la sphère $\mathbb{S}_2$ en dimension 3.

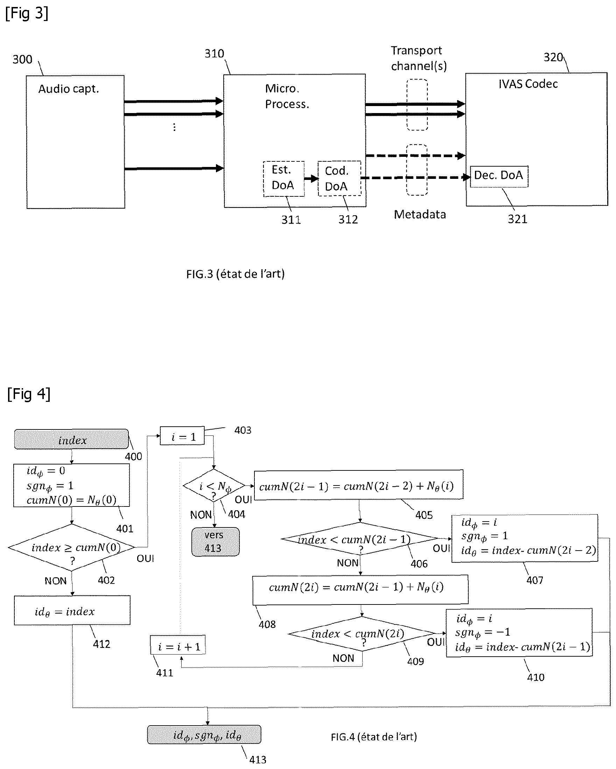

Un autre exemple de format paramétrique pour l'audio immersif est donnée par le format MASA décrit dans la contribution « 3GPP Tdoc S4-180087: On IVAS audio formats for mobile capture devices. Source: Nokia Corporation ». Le principe est résumé à la **figure 3.** On suppose un téléphone mobile équipés de plusieurs microphones (par exemple 4 microphones) placés à des endroits prédéterminés (par exemple deux sur le bas du téléphone, un sur le haut de téléphone et un dernier sur la coque arrière du téléphone). Ces microphones sont vus comme regroupés dans le bloc 300 qui fournit autant de signaux (canaux) que de microphones - avec éventuellement des informations supplémentaires comme le placement ou les caractéristiques des microphones.

Le bloc 310 effectue une analyse paramétrique des signaux issus du bloc 300, selon une approche similaire DirAC, qui fournit des canaux de transport (ou transport channels en anglais) et des métadonnées (metadata en anglais). Cette analyse MASA est en général propriétaire et sélectionnée par le fabricant du téléphone. Le nombre de canaux de transport est typiquement limité à 1 (mono) ou 2 (stéréo), ils peuvent être définis simplement en sélectionnant le microphone primaire dans le cas mono ou deux microphones opposés (par exemple un en bas et un autre en haut du téléphone) dans le cas stéréo. Un exemple de format de métadonnées MASA est décrit par exemple dans la contribution "3GPP Tdoc S4-191167 (Oct. 2019), Description of the IVAS MASA C Reference Software, Source: Nokia Corporation". On s'intéresse particulièrement ici au paramètre appelé « Direction index » et codé sur 16 bits, dont la description dans ce document est la suivante : « Direction d'arrivée du son dans un intervalle temps-fréquence ; Représentation sphérique avec une précision d'environ 1 degrés ; Intervalle de valeurs: "couvre toutes les directions avec une précision d'environ 1° ».

Il s'agit donc d'une direction de source (DoA) selon une grille sphérique 3D dont la résolution (angulaire) est proche de 1 degrés. Cette information DoA est fournie pour chaque trame et sous-bande fréquentielle par une estimation de DoA (bloc 311). Le bloc 312 (à l'intérieur du bloc 310) réalise donc un codage d'informations DoA qui sont codées sur 16 bits par DoA.

Le bloc 320 représente le codec IVAS qui n'est pas encore disponible comme standard 3GPP et qui reste en cours de développement. Cependant, il a été proposé au 3GPP que le format paramétrique MASA définissant des canaux de transports et des métadonnées (dont la DoA par trame et sous-bande) soit un format d'entrée du codec IVAS. Le (futur) codeur IVAS devrait alors mettre en œuvre une étape de décodage des informations DoA (bloc 321) pour pouvoir exploiter pleinement ces informations de DoA et les compresser à débit plus faible. Les détails de réalisation concernant la compression d'un format MASA d'entrée en un train binaire IVAS à débit donné et le décodage associé dépassent le cadre de cette invention, cependant on pourra par exemple noter que le format MASA repose sur un principe étendu du codage DirAC, les canaux de transport peuvent être codés séparément (par un codec cœur mono) ou conjointement (par un codec cœur stéréo) et les métadonnées peuvent être codées à débit plus faible que dans le format d'entrée MASA.

De façon générale, n'importe quelle discrétisation de la sphère $\mathbb{S}_2$ peut être utilisée comme dictionnaire de quantification vectorielle sphérique. Cependant, sans structure particulière, la recherche du plus proche voisin et l'indexation dans ce dictionnaire peuvent s'avérer coûteuses à mettre en œuvre, surtout quand le débit de codage des informations DoA est trop élevé (ex : 16 bits par vecteur 3D indiquant une DoA).

Un exemple de grille sphérique 3D est donné en Annexe et dans le code source attaché à la contribution « 3GPP Tdoc S4-191167 (Oct. 2019), Description of the IVAS MASA C Reference Software, Source: Nokia Corporation ».

La direction spatiale d'une source audio dans une trame donnée et une sous-bande donnée d'une proposition de format WMASA est représentée par deux angles : l'azimut et l'élévation. Les notations utilisées par la suite sont $\phi$ pour l'élévation et $\theta$ pour l'azimut, alors que la convention inverse est utilisée dans le document 3GPP Tdoc S4-191167.

Ce document donne une définition d'une grille sphérique comme-suit :
La grille est constituée de $N_{tot} = 2^{16} - 208 = 65328$ points discrétisant la surface d'une sphère 3D de rayon 1 ; chaque point est représenté par un indice unique sur 16 bits. Cette grille est définie par trois éléments stockés:

- un nombre $N_\phi = 122$ de valeurs discrètes pour coder l'élévation positive (c'est-à-dire $|\phi|$)
- un dictionnaire de quantification scalaire pour l'élévation (pour l'hémisphère Nord correspondant à $|\phi|$) : $\{\hat{\phi}(i), i = 0, ..., N_\phi - 1\}$
- un nombre de points (taille du dictionnaire) $N_\theta(i), i = 0, ...,121$, pour coder l'azimut, à une élévation discrète donnée d'indice i

La définition précise de la grille est détaillée ci-dessous :

- Chaque point sur la grille 3D est donné par une valeur codée d'élévation - décomposée en une valeur absolue codée $\hat{\phi}$ (i) où $i = 0,..., N_\phi$ - 1 et un signe (+1 ou -1) - et une valeur codée d'azimut $\hat{\theta}$ (i, j), $j = 0,.., N_\theta(i)$ - 1 qui dépend de l'indice i d'élévation. La valeur codée d'élévation est $\hat{\phi}$ (0) = 0 pour i = 0 et $\pm\phi(i)$ pour i = 1, ... , $N_\phi$ - 1.
- Le nombre $N_\phi$ = 122 correspond ainsi au nombre d'élévations (codées) de valeur positive (incluant la valeur nulle) ; le dictionnaire de quantification scalaire de l'élévation comprend donc $2N_\phi$ - 1 = 243 valeurs codées en prenant en compte le signe, ces valeurs peuvent être ordonnées en partant du pôle Nord jusqu'au pôle Sud comme :

$+\phi(N_\phi$ - 1) correspondant au Pôle Nord

$$+\hat{\phi}\left(N_\phi - 2\right)$$

...
$+\hat{\phi}$ (1) correspondant à la première couche au-dessus de l'équateur
$\hat{\phi}$ (0) = 0 correspondant à l'équateur
$-\hat{\phi}$ (1) correspondant à la première couche en dessous de l'équateur ...

$$-\hat{\phi}\left(N_\phi - 2\right)$$

$-\hat{\phi}$ ($N_\phi$ - 1) correspondant au Pôle Sud

- L'élévation $\phi$ est codée par quantification scalaire uniforme sur l'intervalle [-88.65, 88.65] degrés avec en plus deux mots de code pour les pôles ($\pm$ 90 degrés). La valeur 0 degrés (correspondant à l'équateur) est contenue dans le dictionnaire. Le pas de quantification est fixé à

$$\delta_\phi = \sin^{-1} \frac{2\sqrt{3}\sin\frac{\pi}{n(1)}}{6\sqrt{1 - \left(\sin\frac{\pi}{n(1)}\right)^2}} + \sin^{-1}\left(\frac{2\sqrt{3}}{3}\sin\frac{\pi}{n(1)}\right)$$

ce qui donne $\delta_\phi \approx 0.7388$ degrés. On a donc $\hat{\phi}$ (i) = $i\delta_\phi$ pour i = 0, ..., $N_\phi$ - 2 et $\hat{\phi}$ (i) = 90 pour i = $N_\phi$ - 1.
- La taille $N_\theta$ (i) du dictionnaire de quantification scalaire uniforme pour l'azimut $\theta$ dépend de l'élévation codée i; le pas en azimut est fixé de sorte que la distance entre mots de code successifs soit identique. La taille des dictionnaires d'azimut est symétrique par rapport à l'équateur (les couches d'élévations négatives ont le même nombre de points que les positives).

Le nombre $N_\theta$ (i) de valeurs d'azimut codées est donné par :

$$N_\theta(0) = 422$$

$$N_\theta(i) = \frac{\pi}{\sin^{-1}\frac{r}{2R(i)}} , i = 1, ..., N_\phi - 2 \text{ où } r = 2\sin\frac{\pi}{N_\theta(0)} \approx 0.014888927181374$$

$$N_\theta\left(N_\phi - 1\right) = 1$$

avec

$$R(1) \approx 0.999916868023083$$

$$R(i) = \cos\left( i\, \delta_\phi \right), i = 2, \ldots, N_\phi - 2$$

En pratique cela donne :

$$N_\theta(i = 0, \ldots, 121) = [$$

422 421 421 421 421 421 420 420 419 419 418 417 416 416 415 414 413 411

410 409 408 406 405 403 401 400 398 396 394 392 390 388 386 384 382 379

377 374 372 369 367 364 361 358 355 352 349 346 343 340 337 333 330 327

323 320 316 313 309 305 301 298 294 290 286 282 278 274 269 265 261 257

252 248 244 239 235 230 225 221 216 211 207 202 197 192 188 183 178 173

168 163 158 153 148 143 137 132 127 122 117 111 106 101  96  90  85  80

 74  69  64  58  53  47  42  37  31  26  20  15   9   1]

On peut vérifier que le nombre total de points dans la grille est :

$$N_{tot} = N_\theta(0) + 2 \sum_{i=1}^{N_\phi - 1} N_\theta(i) = 65328$$

- Chaque élévation codée $\hat{\phi}_i$ définit une zone sphérique (une zone sphérique délimitée par les valeurs d'élévation $\hat{\phi}_i \pm \delta_\phi$) dans laquelle un dictionnaire d'azimut est utilisé. Les dictionnaires d'azimut ont un offset fixé à 0 pour les valeurs i paires et $\frac{\pi}{N_\theta(i)}$ pour les valeurs i impaires. Autrement dit la valeur codée d'azimut (en degrés) est pour $j = 0, \ldots, N_\theta(i) - 1$ :

$$\hat{\theta}(i,j) = \begin{cases} 360\, j/\, N_\theta(i) - 180 & i \text{ paire} \\ 360\, (j+0.5)/\, N_\theta(i) - 180 & i \text{ impaire} \end{cases}$$

Le document cité ci-dessus donne une méthode pour coder un point donné $(\phi, \theta)$. Etant donné un point $(\phi, \theta)$ à coder, la quantification (recherche du plus proche voisin) sur la grille s'effectue selon les étapes suivantes :

- Le signe $sgn_\phi$ et la valeur absolue $|\phi|$ de l'élévation $\phi$ sont déterminés ; en particulier $sgn_\phi = 1$ si $\phi \geq 0$, -1 autrement. La valeur absolue $|\phi|$ est codée par quantification scalaire uniforme en retenant les deux plus proches voisins. Ce codage avec « 2 survivants » peut par exemple être effectué par une recherche préliminaire du plus proche voisin dans le dictionnaire d'élévation (positive), par recherche exhaustive.

$$i_1 = \arg\min_{i=0,\ldots,N_\phi-1} \left| |\phi| - \hat{\phi}(i) \right| = \arg\min_{i=0,\ldots,N_\phi-1} \left( |\phi| - \hat{\phi}(i) \right)^2$$

On note $i_1$ l'indice du plus proche voisin. Ensuite on détermine l'indice $i_2$ de la seconde valeur la plus proche selon la valeur de $i_1$ :

o $i_2 = 1$ si $i_1 = 0$
o $i_2 = N_\phi - 2$ si $i_1 = N_\phi - 1$
o $i_2 = \arg\min_{i=i_1-1,i_1+1} \left| |\phi| - \hat{\phi}(i) \right|$ si $0 < i_1 < N_\phi - 1$

On obtient ainsi deux candidats $sgn_\phi \cdot \hat{\phi}(i_1)$, $sgn_\phi \cdot \hat{\phi}(i_2)$, où $\hat{\phi}(i_k)$ est l'élévation absolue codée, $k = 1$ ou 2, pour représenter l'élévation $\phi$. En termes de valeur absolue, ces deux candidats sont simplement $\phi(i_1)$ et $\phi(i_2)$.

- L'azimut $\theta$ est codé par quantification scalaire uniforme (avec un offset dépendant de l'élévation) selon le dictionnaire correspondant $\{\hat{\theta}(i_k, j), j = 0, \ldots, N_\theta(i_k)\}$ respectivement à $k = 1$ ou 2. On obtient l'indice $j_k$ de la façon suivante :

$$j_k = mod_{N_\theta(i_k)} \left\lfloor \frac{|\theta - \Delta + 180/N_\theta(i_k)|}{360/N_\theta(i_k)} \right\rfloor$$

où $\lfloor \cdot \rfloor$ et l'arrondi à l'entier inférieur, $\Delta = 0$ si $i_k$ est pair, $180/N_\theta(i_k)$ si $i_k$ est impair, et $mod_{N_\theta(i_k)}$ est l'opération de modulo telle que $mod_{N_\theta(i_k)}(i) = i$ si $i = 0, ..., N_\theta(i_k) - 1$ et $mod_{N_\theta(i_k)}(N_\theta(i_k)) = 0$. L'indice $j_k$ vérifie donc : $0 \leq j_k \leq N_\theta(i_k) - 1$.

- Le meilleur candidat est sélectionné en minimisant la distance sphérique entre $(\phi, \theta)$ et $(sgn_\phi \cdot \hat{\phi}(i_k), \hat{\theta}(i_k, j_k))$ en fonction de $k = 1$ ou $2$, ce qui peut s'écrire indépendamment du signe $sgn_\phi$ (puisque le signe de $sgn_\phi \cdot \hat{\phi}(i_k)$ est identique à celui de $\phi$) comme :

$$d(i_k, j_k) = -\left(\sin\phi \sin\widehat{\phi}(i_k) + \cos\phi \cos\widehat{\phi}(i_k) \cos\left(\theta - \widehat{\theta}(i_k, j_k)\right)\right)$$

La paire $(sgn_\phi \cdot \hat{\phi}(i_k), \hat{\theta}(i_k j_k))$ la plus proche au sens de cette distance est sélectionnée comme valeur quantifiée à indexer. On note ce point sélectionné $(sgn_\phi \cdot \hat{\phi}(id_\phi), \hat{\theta}(id_\phi, id_\theta))$ où : $k^* = \arg \max_{k=1,2} d(i_k, j_k)$ et $id_\phi = i_{k^*}$ et $id_\theta = j_{k^*}$

L'indice de quantification (sur 16 bits), noté ici *index,* du point sélectionné $(sgn_\phi \cdot \hat{\phi}(id_\phi), \theta(id_\phi, id_\theta))$ est obtenu par énumération des points sur la grille en partant de l'équateur (tous les points d'élévation $(\hat{\phi}(0) = 0)$, puis en considérant la première couche au-dessus de l'équateur (tous les points d'élévation $+\hat{\phi}(1) = \delta_\phi$), puis la première couche au dessous de l'équateur (tous les points d'élévation $-\hat{\phi}(1) = -\delta_\phi$), etc.

On obtient un indice sous la forme *index* dans l'intervalle $0, ..., N_{tot} - 1$ où :

$$index = \begin{cases} id_\theta & si\ id_\phi = 0 \\ cumN\left(2id_\phi - 2\right) + id_\theta & si\ id_\phi > 0\ et\ sgn_\phi > 0 \\ cumN\left(2id_\phi - 1\right) + id_\theta & si\ id_\phi > 0\ et\ sgn_\phi < 0 \end{cases}$$

Les valeurs de cardinalités cumulatives *cumN* sont calculées au fil de l'eau à chaque fois que l'indice *index* est déterminé :

$$cumN(0) = N_\theta(0)$$

$$cumN(1) = cumN(0) + N_\theta(1) = N_\theta(0) + N_\theta(1)$$

$$cumN(2) = cumN(1) + N_\theta(1) = N_\theta(0) + 2N_\theta(1)$$

$$cumN(3) = cumN(2) + N_\theta(2) = N_\theta(0) + 2N_\theta(1) + N_\theta(2)$$

$$cumN(4) = cumN(3) + N_\theta(2) = N_\theta(0) + 2N_\theta(1) + 2N_\theta(2)$$

....

$$cumN(2i - 1) = cumN(2i - 2) + N_\theta(i)$$

$$cum(2i) = cumN(2i - 1) + N_\theta(i)$$

La méthode de décodage du document cité ci-dessus est précisée à l'organigramme de la **figure 4.**

Le décodage consiste, à partir de l'indice *index* (bloc 400), à retrouver les informations d'élévation $id_\phi$, $sgn_\phi$ et d'azimut $id_\theta$ (bloc 413), ce qui permet ensuite de reconstruire le

$$\text{point} \left(sgn_\phi \cdot \widehat{\phi}(id_\phi), \hat{\theta}(id_\phi, id_\theta)\right).$$

Le principe du décodage est de comparer successivement la valeur *index* aux valeurs de cardinalités cumulatives successives *cumN* (ou sommes de cardinalités) qui sont calculées au fil de l'eau de façon récursive pour i = 0, ...,$N_\phi$ - 1, en tenant compte du fait que les cardinalités $N_\theta(i)$ sont identiques pour les élévations de même valeur absolue (dans les hémisphères Nord et Sud). Le signe de l'élévation $sgn_\phi$ est décodé en exploitant l'ordre prédéfini d'écriture des couches sphériques : équateur, première couche d'élévation positive (+), première couche d'élévation négative (-), ..., jusqu'aux pôle Nord (+), pôle Sud (-)...

Les valeurs de $id_\phi$, $sgn_\phi$, *cumN(0)* sont initialisées (bloc 401).

Si *index* ≥ cumN(0) (bloc 402), on effectue le décodage des informations pour les « couches d'élévation » hors équateur d'indice i > 0. La recherche de la « couche d'élévation » s'effectue par une boucle en partant de i = 1 jusqu'à i = $N_\phi$ - 1 (blocs 403, 404, 411). A l'itération i, la cardinalité cumulative est calculée de façon récursive (blocs 405, 408) et comparée à l'indice (bloc 406, 409) afin de décoder les indices (blocs 407, 410).

Si *index* < cumN(0) (bloc 402), on effectue le décodage des indices des informations pour la couche correspondant à l'équateur (bloc 412).

On notera que dans la réalisation dans le code source attaché à la contribution 3GPP Tdoc S4-191167 un test pour vérifier si i = $N_\phi$ - 1 est mis en œuvre pour décoder explicitement $id_\phi$ = $N_\phi$ - 1, $sgn_\phi$=-1, $id_\theta$ = 0. Cette partie n'est pas reprise car le signe $sgn_\phi$=1 devrait également être possible dans une grille contenant le pôle Nord et Sud et elle est normalement inutile car la définition $cumN(N_\phi$ - 1) doit permettre le décodage des points associés aux pôles. La gestion spécifique des pôles peut être négligée, l'important concerne le principe d'un décodage itératif par comparaison de l'indice avec une cardinalité cumulative (ou somme de cardinalités) calculé au fur et à mesure.

Une fois les indices $id_\phi$, $sgn_\phi$ et $id_\theta$ décodés, la reconstruction des coordonnées sphériques ($sgn_\phi \cdot \hat\phi (id_\phi)$, $\hat\theta (id_4$, $id_\theta$)) reprend, en 413, la définition de la grille définie précédemment avec:

$$\hat\phi(i) = i\delta_\phi \text{ pour } i = 0, ..., N_\phi - 2 \text{ et } \hat\phi(i) = 90 \text{ pour } i = N_\phi - 1.$$

$$\hat\theta(i,j) = \begin{cases} 360\, j/\, N_\theta(i) - 180 & i \text{ pair} \\ 360\, (j+0.5)/\, N_\theta(i) - 180 & i \text{ impair} \end{cases}$$

Cette méthode telle que mise en œuvre dans la contribution 3GPP Tdoc S4-191167 citée précédemment nécessite un pré-stockage de $N_\phi$ = 122 valeurs flottantes ($\hat\phi$(i)) de quantification scalaire de l'élévation (positive), $N_\phi$ valeurs entières donnant $N_\theta(i)$ valeurs pour chaque couche d'élévation (positive), et une valeur entière donnant $N_\phi$. La grille n'utilise pas toutes les valeurs possibles d'indices sur 16 bits, puisque 208 indices (de 65328 à 65535) sont inutilisés.

Cette méthode a comme principal défaut que sa complexité est très élevée, de l'ordre de 123 WMOPS au codage (pour millions d'opérations pondérées par seconde) et 12 WMOPS au décodage, en supposant 24 sous-bandes (donc 24 DoA par trame) et une résolution temporelle de 5 ms (donc une trame toutes les 5 ms). Ce coût est élevé en particulier par la mise en œuvre de la quantification scalaire de l'élévation par recherche dans un dictionnaire stocké et surtout par le calcul au fil de l'eau des cardinalités cumulatives *cumN(i)*.

Il existe donc un besoin d'améliorer les méthodes de l'état de l'art de quantification de données sphériques en dimension 3D, en particulier afin de coder efficacement des données de DoA, avec si possible une complexité la plus réduite possible et en évitant d'avoir des indices non utilisés pour un nombre total de points donné (ou de façon équivalente un budget de bits donné).

L'invention vient améliorer l'état de la technique.

A cet effet, l'invention vise un procédé de codage d'une direction spatiale d'une source sonore comme défini dans la revendication 1.

Ainsi, les valeurs de cardinalité cumulative utilisées pour définir le dictionnaire de quantification sphérique, notamment pour déterminer le nombre de niveaux de quantification pour la coordonnée d'azimut, reposent sur une estimation directe de l'aire de zones sphériques, évitant ainsi un calcul au fil de l'eau et de façon récursive de la somme de cardinalités utilisée dans la méthode proposée dans l'état de l'art qui est très consommatrice en ressources.

La méthode proposée ici est nettement moins consommatrice en ressources, elle est par exemple de l'ordre de 2 WMOPS pour le codage et 1 WMOPS pour le décodage.

La définition d'un tel dictionnaire de quantification permet d'autre part d'exploiter tous les points (ou mots de code) possibles du dictionnaire de façon à rendre plus efficace la quantification et éviter d'avoir des indices (ou mots de code) inutilisés dans la grille. L'invention est en particulier appliquée pour mettre en œuvre une méthode plus efficace de codage et de décodage d'informations DoA sur 16 bits pour définir le format MASA en entrée d'un codage IVAS.

Dans un mode de réalisation, le codage de l'élévation inclut des niveaux correspondant à l'équateur et aux pôles de la sphère 3D, ce qui permet d'inclure tous les points particuliers (équateur et pôles) de la sphère dans le dictionnaire de quantification. Dans un mode de réalisation, un nombre de points pour le codage de l'azimut est prédéterminé pour le niveau d'élévation correspondant à l'équateur et le nombre total de points est obtenu en soustrayant à un nombre de points cible le nombre de points prédéterminé correspondant à l'équateur et chacun des pôles nord et sud de la sphère selon l'expression suivante: $N'_{tot} = N_{tot} - N_\theta(0) - 2N_\theta(N_\phi - 1)$,

$N_{tot}$ étant le nombre de points cible de la sphère pour un budget de bits donné,

$N_\theta(0)$, le nombre de points prédéterminé pour le niveau d'élévation correspondant à l'équateur ; et

$2N_\theta(N_\phi - 1)$ le nombre de points prédéterminé pour les pôles nord et sud de la sphère.

La méthode est ainsi adaptée à la connaissance du nombre de points pour certaines couches sphériques particulières comme celle correspondant à l'équateur et celles correspondants aux pôles qui peuvent être définis à une valeur fixe.

Dans un mode particulier de réalisation, la valeur de cardinalité cumulative pour un indice d'élévation codée est représentative d'un nombre de points proportionnel au nombre total de points selon l'aire ($A_i$) d'une zone sphérique délimitée par le plan horizontal supérieur du niveau d'élévation positive de l'indice d'élévation codée et ce même plan de la sphère symétrique par rapport à l'équateur auquel on retranche l'aire ($A_0$) correspondant au niveau d'élévation de l'équateur, selon le rapport suivant:

$$\frac{(A_i - A_0)}{\left(A_{N_\phi - 2} - A_0\right)} N_{tot}{}',$$

$N_\phi$ - 2 étant le nombre de niveaux de quantification de l'élévation sans l'équateur et les pôles nord et sud de la sphère et $A_{N_\phi-2}$, l'aire de la zone sphérique correspondant à un indice d'élévation $N_\phi$ - 2.

Dans une variante de réalisation, la valeur de cardinalité cumulative pour un indice d'élévation codée est représentative d'un nombre de points proportionnel au nombre total de points selon l'aire ($A'_i$) d'une zone sphérique délimitée par le plan horizontal supérieur du niveau d'élévation positive de l'indice d'élévation codée et celui de l'équateur auquel on retranche la moitié de l'aire correspondant au niveau d'élévation de l'équateur, selon le rapport suivant:

$$\frac{(A'_i - A_0/2)}{\left(A'_{N_\phi - 2} - A_0/2\right)} N_{tot}{}',$$

$N_\phi$ - 2 étant le nombre de niveaux de quantification de l'élévation sans l'équateur et les pôles nord et sud de la sphère et $A'_{N_\phi-2}$, l'aire de la zone sphérique correspondant à un indice d'élévation $N_\phi$ - 2.

Ces rapports d'aires de zones sphériques permettent d'estimer de façon simple et directe, par une simple règle de trois, le nombre de points dans les zones sphériques correspondantes qui sont des sous-ensembles de la surface complète de la sphère 3D.

Ces rapports permettent d'exprimer des valeurs de cardinalité cumulatives de la façon suivante :

$$cumN(i) = 2Arr_i\left(\frac{N'_{tot}}{2}\frac{\sin\left((i+\frac{1}{2})\delta_\phi\right) - \sin\left(\frac{\delta_\phi}{2}\right)}{\sin\left((N_\phi - \frac{1}{2})\delta_\phi\right) - \sin\left(\frac{\delta_\phi}{2}\right)}\right)$$

avec

$i = 1, ..., N_\phi$ - 2, $N_\phi$ - 2 étant le nombre de niveaux de quantification de l'élévation sans l'équateur et les pôles nord et sud de la sphère,

$Arr_i()$ étant un arrondi à l'entier le plus proche dépendant de $i$, $2Arr_i\left(\frac{x}{2}\right)$

correspondant à un arrondi à un entier pair et $\delta_\phi$ un pas de quantification de l'élévation donné.

Dans un mode de réalisation, le codage de l'élévation donne un indice d'élévation codée (i) sur un nombre de niveau ($N_\phi$) d'élévation et une information de signe. Ainsi, seule une demi-sphère est considérée pour définir le dictionnaire de quantification, le nombre de niveaux d'élévation et le nombre de points par niveaux étant symétriques de part et d'autre de l'équateur.

Dans un mode de réalisation, un indice de quantification global à transmettre (*index*) est déterminé en fonction d'un indice d'azimut codé par quantification scalaire sur le nombre de points par niveau ($N_\theta(i)$) déterminé et d'une valeur de cardinalité cumulative obtenue en fonction au moins de l'indice d'élévation codé.

Les valeurs de cardinalité ainsi définies peuvent être estimées directement (de façon analytique) pour définir l'indice global à transmettre, ce qui permet de réduire la complexité maximale de calcul.

Un exemple n'étant pas couvert par la formulation des revendications, mais étant considéré comme utile pour la compréhension de l'invention, se rapporte également à un procédé de décodage d'une direction spatiale d'une source sonore, cette direction étant défini par des coordonnées sphériques comprenant une coordonnée d'élévation et une coordonnée d'azimut, dans lequel un dictionnaire de quantification sphérique est défini sur une sphère 3D par un codage de l'élévation et de l'azimut, et dans lequel :

- le décodage de l'élévation utilise une quantification scalaire, donnant au moins un indice d'élévation décodée (i) sur un nombre de niveau ($N_\phi$) d'élévation ,
- le décodage de l'azimut utilise une quantification scalaire, en fonction d'un nombre de points par niveau ($N_\theta(i)$) dépendant de l'indice de l'élévation décodée (i),
- le nombre de points par niveau ($N_\theta(i)$) est déterminé en fonction de deux valeurs de cardinalité cumulative successives (*cumN(i), cumN(i - 1)*),
- la valeur de cardinalité cumulative (*cumN(i)*) pour un indice d'élévation décodée (i) étant représentative d'un nombre de points proportionnel à un nombre total de points et selon l'aire d'une zone sphérique comprenant au moins une zone délimitée par le plan horizontal supérieur ( $\phi = (i + \frac{1}{2})\delta_\phi$ ) du niveau d'élévation positive de l'indice d'élévation décodée (i) et un plan horizontal inférieur de la sphère.

Le procédé de décodage a les mêmes avantages que le procédé de codage, il permet une optimisation des ressources de calcul par l'utilisation d'un dictionnaire de quantification sphérique optimisé.

De la même façon que pour le codage et selon les mêmes avantages, dans un mode de réalisation, le décodage de l'élévation inclut des niveaux correspondant à l'équateur (0°) et aux pôles (+/-90°) de la sphère 3D.

Selon un mode particulier de réalisation, un nombre de points ($N_\theta(0)$) pour le décodage de l'azimut est prédéterminé pour le niveau d'élévation correspondant à l'équateur et le nombre total de points ( $N'_{tot}$ ) est obtenu en soustrayant à un nombre de points cible ($N_{tot} = 2^{16}$) le nombre de points prédéterminé correspondant à l'équateur et chacun des pôles nord et sud de la sphère selon l'expression suivante:

$$N'_{tot} = N_{tot} - N_\theta(0) - 2N_\theta(N_\phi - 1),$$

$N_{tot}$ étant le nombre de points cible de la sphère pour un budget de bits donné,
$N_\theta(0)$, le nombre de points prédéterminé pour le niveau d'élévation correspondant à l'équateur ; et
$2N_\theta(N_\phi - 1)$ le nombre de points prédéterminé pour les pôles nord et sud de la sphère.

Dans un mode de réalisation, la valeur de cardinalité cumulative *(cumN(i))* pour un indice d'élévation décodée (i) est représentative d'un nombre de points proportionnel au nombre total de points selon l'aire ($A_i$) d'une zone sphérique délimitée par le plan horizontal supérieur ( $\phi = (i + \frac{1}{2})\delta_\phi$ ) du niveau d'élévation positive de l'indice d'élévation décodée (i) et ce même plan de la sphère symétrique par rapport à l'équateur ( $\phi = -(i + \frac{1}{2})\delta_\phi$ ) auquel on retranche l'aire ($A_0$) correspondant au niveau d'élévation de l'équateur, selon le rapport suivant:

$$\frac{(A_i - A_0)}{\left(A_{N_\phi - 2} - A_0\right)} N_{tot}'$$

$N_\phi$ - 2 étant le nombre de niveaux de quantification de l'élévation sans l'équateur et les pôles nord et sud de la sphère et $A_{N_\phi - 2}$, l'aire de la zone sphérique correspondant à un indice d'élévation $N_\phi$ - 2.

Dans un exemple possible, l'expression de la valeur de cardinalité cumulative est la suivante :

$$cumN(i) = 2Arr_i\left(\frac{N'_{tot}}{2}\frac{\sin\left((i + \frac{1}{2})\delta_\phi\right) - \sin\left(\frac{\delta_\phi}{2}\right)}{\sin\left((N_\phi - \frac{1}{2})\delta_\phi\right) - \sin\left(\frac{\delta_\phi}{2}\right)}\right)$$

avec

$i = 1, ..., N_\phi - 2, N_\phi - 2$ étant le nombre de niveaux de quantification de l'élévation sans l'équateur et les pôles nord et sud de la sphère,

$Arr_i()$ étant un arrondi à l'entier le plus proche dépendant de $i$, $2Arr_i\left(\frac{x}{2}\right)$ correspondant à un arrondi à un entier pair et $\delta_\phi$ un pas de quantification de l'élévation donné.

Selon un mode de réalisation, le décodage de l'élévation donne un indice d'élévation décodée (i) sur un nombre de niveau ($N_\phi$) d'élévation et une information de signe. Dans un mode de réalisation, le décodage comprend la réception d'un indice de quantification global (*index*), et la détermination à partir de cet indice, d'une valeur de cardinalité cumulative obtenue en fonction d'au moins l'indice d'élévation décodé et d'un indice d'azimut décodé sur un nombre de points par niveau ($N_\theta(i)$) déterminé. L'invention vise un dispositif de codage comportant un circuit de traitement pour la mise en œuvre des étapes du procédé de codage tel que décrit précédemment.

Enfin l'invention se rapporte à un support de stockage, lisible par un processeur, mémorisant un programme informatique comportant des instructions pour l'exécution du procédé de codage décrit précédemment.

D'autres caractéristiques et avantages de l'invention apparaîtront plus clairement à la lecture de la description suivante de modes de réalisation particuliers, donnés à titre de simples exemples illustratifs et non limitatifs, et des dessins annexés, parmi lesquels :

[Fig 1] décrite précédemment, illustre un dispositif de codage de type DirAC avec un codage de données sphériques en dimension 3;

[Fig 2] décrite précédemment, illustre un dispositif de décodage de type DirAC avec un décodage de données sphériques en dimension 3;

[Fig 3] décrite précédemment, illustre un dispositif de type smartphone équipé de plusieurs microphones avec une pré-analyse spatiale de type MASA pour fournir en entrée d'un codage un format de type MASA;

[Fig 4] décrite précédemment illustre sous forme d'organigramme les étapes mises en œuvre dans le décodage de données sphériques en dimension 3 ;

[Fig 5a] illustre des zones sphériques induites par la discrétisation de l'élévation pour définir le dictionnaire de quantification sphérique selon un mode de réalisation de l'invention ;

[Fig 5b] illustre les aires utilisées pour la détermination du nombre de points en azimut pour définir le dictionnaire de quantification sphérique selon un mode de réalisation de l'invention ;

[Fig 6a] illustre sous forme d'organigrammes les étapes mises en œuvre dans un procédé de codage selon un mode de réalisation de l'invention ;

[Fig 6b] illustre sous forme d'organigramme l'étape d'indexation mise en œuvre dans le procédé de codage selon un mode de réalisation de l'invention ;

[Fig 7a] illustre sous forme d'organigrammes les étapes mises en œuvre dans un procédé de décodage ;

[Fig 7b] illustre sous forme d'organigramme les étapes de décodage des indices de quantification mises en œuvre dans le procédé de décodage

[Fig 8a] illustre sous forme d'un diagramme l'indexation (dans l'hémisphère Nord de la sphère 3D) mise en œuvre dans un procédé de décodage

[Fig 8b] illustre sous forme d'un diagramme l'indexation (dans l'hémisphère Sud de la sphère 3D) mise en œuvre dans un procédé de décodage; et

[Fig 9] illustre des exemples de réalisation structurelle d'un dispositif de codage, selon un mode de réalisation de l'invention, et d'un dispositif de décodage.

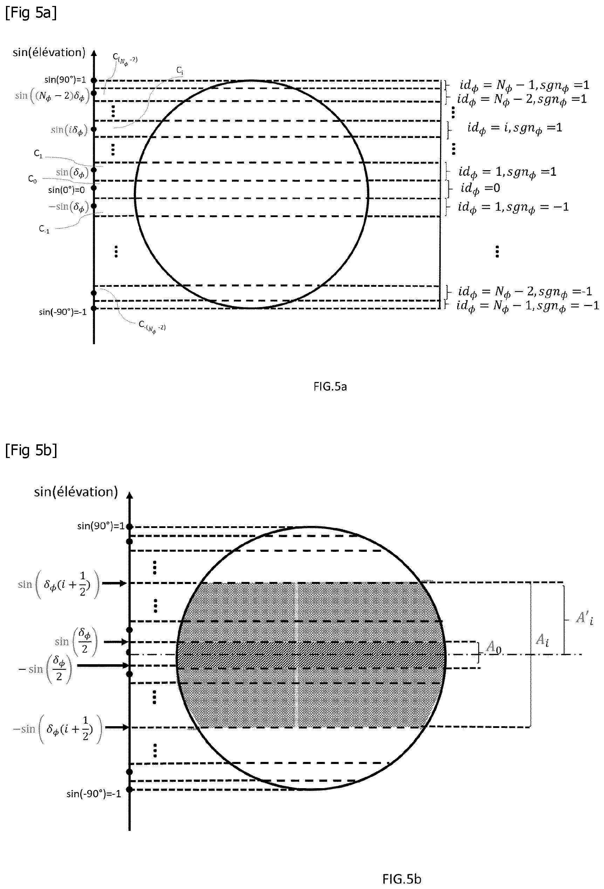

L'invention décrite ci-après se rapporte à la quantification de données sphériques en dimension 3. Ceci s'applique à titre d'exemple pour le codage et le décodage des directions spatiales de sources sonores (DoA), pour un codage et décodage par exemple de données de type MASA comme décrit ultérieurement en référence aux figures 5 à 7. Dans des variantes, l'invention pourra s'appliquer à un codage de type DirAC ou tout type de codage/décodage de données audio ou un codage de tout autre type de données où une information de direction 3D est codée.

Sans perte de généralité, on prend ici la définition des coordonnées sphériques en 3D en degrés selon la convention géographique qui est utilisée dans la description de la proposition de référence de format MASA.

On omet le rayon qui est ici fixé à 1 en ne gardant que l'azimut et l'élévation dans le cas où on code une direction de sources (ou DoA) comme dans un schéma de type DiRAC ou MASA. Dans des variantes et pour certaines applications (ex : quantification d'une sous-bande en codage par transformée), il sera possible de coder un rayon séparément (correspondant à un niveau d'amplitude moyenne par sous-bande par exemple).

Dans des variantes, d'autres unités que les degrés (ex : radians) seront utilisées, et d'autres conventions que la convention géographique seront utilisées par exemple l'élévation pourra être remplacée par la co-latitude. Ainsi, d'autres systèmes de coordonnées sphériques équivalents (obtenus par exemple par permutation ou inversion de coordonnées cartésiennes) pourront être utilisés selon l'invention - il suffira d'appliquer les conversions nécessaires dans la définition des dictionnaires de quantification scalaire, la reconstruction, etc. Le codage et le décodage selon l'invention s'applique à toutes les définitions de coordonnées sphériques, on peut ainsi remplacer $\phi$, $\theta$ par d'autres coordonnées sphériques, en adaptant la conversion entre coordonnées cartésiennes et coordonnées sphériques.

**La figure 5a** illustre une représentation partielle en 2D d'un dictionnaire de quantification sphérique (grille) selon un mode de réalisation de l'invention. Selon l'invention, le dictionnaire de quantification sphérique est défini par un codage de l'élévation et de l'azimut. Le codage de l'élévation utilise une quantification scalaire, avec une discrétisation de l'élévation qui, selon un mode de réalisation, inclut des niveaux correspondant à l'équateur (élévation nulle) et aux pôles (élévation +/-90°) de la sphère 3D. Le codage de l'élévation donne au moins un indice d'élévation codée (i) sur un nombre de niveau d'élévation.

Cette discrétisation utilise un nombre de niveaux positifs ($N_\phi$) pour l'hémisphère Nord et une indication de signe d'élévation (indiquant l'hémisphère Nord ou Sud), ce qui revient à $2N_\phi$ - 1 niveaux pour coder l'élévation dans les deux hémisphères Nord et Sud de la sphère 3D.

Comme illustré à la figure 5a, on peut donc voir le dictionnaire de quantification sphérique encore nommé ci-après grille selon l'invention comme un ensemble de $2N_\phi$ - 1 « couches sphériques » ou « tranches horizontales » représentés en $C_0$, $C_1$, $C_{-1}$, ... $C_i$,..., $C_{(N_\phi-1)}$, $C_{-(N_\phi-1)}$ induites de la quantification d'élévation (les limites de chaque tranches en pointillés sont données par les seuils de décision de la quantification d'élévation, hors pôles). La surface de l'hémisphère Nord est divisée en couches, $C_0$ (seule la moitié supérieure de $C_0$, au-dessus de l'équateur, est dans l'hémisphère Nord), $C_1$, ...$C_i$,..., $C_{(N_\phi-1)}$, tandis que la surface de l'hémisphère Sud est divisée en couches $C_0$ (seule la moitié inférieure de $C_0$, au-dessous de l'équateur, est dans l'hémisphère Sud), $C_{-1}$, ...$C_{-i}$,..., $C_{-(N_\phi-1)}$.

On notera qu'à la figure 5a, on montre une projection 2D de la sphère 3D, en prenant un plan de coupe vertical arbitraire. L'axe 0z en coordonnées cartésiennes est indiqué, avec une graduation selon le sinus de l'élévation, puisque la coordonnée z correspond à z = sin $\phi$ dans la convention choisie.

Le codage de l'azimut utilise une quantification scalaire, en fonction du nombre de niveaux d'azimut ($N_\theta(i)$) (encore appelé nombre de points par niveau) dépendant de l'indice de l'élévation (positive ou absolue) codée (i=0,..., $N_\phi$ - 1), ce nombre de niveaux $N_\theta(i)$ étant symétrique de part et d'autre de l'équateur pour les hémisphères Nord et Sud.

La détermination de ce nombre de niveaux d'azimut est décrite ci-après.

Pour ne pas surcharger cette figure on ne montre pas la subdivision de ces couches horizontales en « régions » équiréparties selon la discrétisation de l'azimut avec un nombre $N_\theta(i)$ de niveaux d'azimut dépendant du niveau en élévation.

La grille sphérique selon l'invention discrétise séparément l'élévation et l'azimut par quantification scalaire, avec une discrétisation uniforme de l'azimut selon un nombre de niveaux $N_\theta(i)$) dépendant de la valeur codée $i$ d'élévation (positive ou absolue).

Cependant, la recherche optimale du plus proche voisin dans la grille implique de sélectionner deux candidats en élévation et donc aussi deux candidats associés en azimut pour sélectionner le meilleur candidat ; ceci revient donc à un codage conjoint même s'il est en pratique séparé, les vraies régions de décision de la grille (en termes de régions de Voronoï à la surface de la sphère) ne sont donc pas des rectangles sphériques. Pour des fins d'indexation (codage de l'indice global et décodage), la discrétisation de la surface de la sphère 3D peut être malgré tout vue comme un découpage séparé en élévation et en azimut pour obtenir des rectangles sphériques (hors calottes au niveau des pôles).

On code séparément les coordonnées $\phi$ et $\theta$, avec un dictionnaire {$s.\hat{\phi}(id_\phi)$, $id_\phi$ = 0, ..., $N_\phi$ - 1,s = +1 ou - 1} de quantification scalaire avec $N_\phi$ niveaux pour $|\phi|$ et avec une information de signe s (indiquant l'hémisphère Nord pour s =+1 ou Sud pour s = -1) et un ensemble de dictionnaires {$\hat{\theta}(i,j)$, j = 0,..., $N_\theta(i)$ - 1} de quantification scalaire uniforme avec $N_\theta(i)$ niveaux pour $\theta$ en fonction de l'indice i de l'élévation (positive ou absolue) codée.

Le nombre total de points de la sphère discrétisée selon les différents nombres de niveaux déterminés, encore appelée nombre total de point dans la grille 3D est donné, dans un mode particulier de réalisation par :

$$N_{tot} = N_\theta(0) + 2 \sum_{i=1}^{N_\phi-1} N_\theta(i)$$

Ce nombre inclut les points $N_\theta(0)$ sur le niveau d'élévation (la couche sphérique) correspondant à l'équateur (C0, $id_\phi$ = 0) et les points $N_\theta(i)$ de chaque niveau d'élévation positive d'indice i = 1, ... , $N_\phi$ - 1, encore appelé couche d'élévation Ci, ces derniers étant symétriques entre l'hémisphère Nord et Sud donc comptés en double.

La grille sphérique est donc définie comme le dictionnaire de quantification vectorielle sphérique suivant (avec un rayon supposé égal à 1 par convention) :

$$\left\{ \left( s.\hat{\phi}(i), \hat{\theta}(i,j) \right) | s = -1, 1 \; si \; i > 1, 1 \; si \; i = 0; \; i = 0, ..., N_\phi - 1; j = 0, ..., N_\theta(i) - 1 \right\}$$

On notera que la valeur de s pour i = 0 est arbitraire, puisque $\hat{\phi}$ (i = 0) = 0.

Dans le mode de réalisation privilégié, on définit une grille 3D pour un budget de bits donné sur par exemple 16 bits, donnant ainsi un nombre total de points de la sphère, soit $N_{tot}$ = $2^{16}$. Dans des variantes, d'autres valeurs de $N_{tot}$ (donc de budget de bits) seront possibles.

L'élévation est codée par quantification scalaire sur $N_\phi$ niveaux de reconstruction. Dans le mode de réalisation privilégié, on fixe $N_\phi$ = 122 comme nombre de niveaux positifs comme dans la grille du format MASA décrite précédemment. Cela permet en particulier d'avoir un nombre pair de niveaux dans l'hémisphère Nord ($N_\phi$ incluant le pôle Nord et l'équateur). Si l'on prend aussi en compte l'hémisphère Sud, l'élévation est donc codée sur $2N_\phi$ - 1 niveaux (en ne comptant qu'une fois l'équateur). L'inclusion des pôles permet une représentation complète de la sphère, l'impact est minime car seuls 2 points de la grille sont associés aux pôles (lorsque le signe est appliqué).

Pour le codage de l'élévation par quantification scalaire, on définit un pas de quantification uniforme $\delta_\phi$ (hors pôles) et on prend :

$$\hat{\phi}(i) = i\delta_\phi \text{ pour } i = 0, ..., N_\phi - 2 \text{ et } \hat{\phi}(i) = 90 \text{ pour } i = N_\phi - 1$$

avec par exemple $\delta_\phi$ = 0.7388 degrés comme dans la grille du format MASA décrite précédemment. Le pas de quantification est uniforme sur l'intervalle [-$\hat{\phi}$ ($N_\phi$ - 2), $\hat{\phi}$ ($N_\phi$ - 2)] ou [-($N_\phi$ - 2)$\delta_\phi$, ($N_\phi$ - 2)$\delta_\phi$], si le signe est pris en compte.

L'azimut $\theta$ est codé par quantification scalaire sur $N_\theta(i)$ niveaux. De façon préférentielle on utilise une quantification scalaire uniforme avec un dictionnaire de quantification scalaire uniforme en tenant compte de la nature cyclique de l'intervalle [-180,180] degrés :

$$\hat{\theta}(i,j) = \begin{cases} 360\, j / N_\theta(i) - 180 & i \text{ paire} \\ 360\, (j + 0.5) / N_\theta(i) - 180 & i \text{ impaire} \end{cases}$$

Les dictionnaires d'azimut ont un décalage encore appelé offset fixé à 0 pour les valeurs i paires et $\frac{\pi}{N_\theta(i)}$ pour les valeurs i impaires, pour « décaler » la « tranche horizontale » (couche sphérique) de la sphère (délimitée par les seuils de décision d'élévation) associée à chaque élévation d'indice i de sorte que les azimuts codés soient le moins alignés possibles d'une couche successive à l'autre.

Dans des variantes, on pourra utiliser une quantification scalaire uniforme sur l'intervalle [0,90] degrés (en incluant les valeurs 0 et 90 comme niveaux de reconstruction) pour le codage de l'élévation :

$$\hat{\phi}(i) = \frac{i}{N_\phi - 1} 90, \qquad i = 0, ..., N_\phi - 1$$

Cela revient à changer le pas de quantification $\delta_\phi$ pour avoir $\delta_\phi$ = 90/($N_\phi$ - 1), soit $\delta_\phi \approx$ 0.7438 quand $N_\phi$ = 122, dans ce cas les pôles sont naturellement inclus comme mots de code. Le pas de quantification est uniforme sur l'intervalle [-$\hat{\phi}$ ($N_\phi$- 1), $\hat{\phi}$ ($N_\phi$- 1)], soit [-90,90] degrés, si le signe est pris en compte..

Dans d'autres variantes, on pourra changer le nombre de niveaux $N_\phi$ ou prendre d'autres définitions du dictionnaire de quantification scalaire {$\phi$(i), i = 0,..., $N_\phi$ - 1} pour l'élévation (positive ou absolue). On suppose cependant que $\hat{\phi}$ (i = 0) = 0° et $\hat{\phi}$ (i = $N_\phi$ - 1) = 90°.

Dans d'autres variantes, l'offset appliqué sur l'azimut en fonction de la couche d'élévation pourra être différent, l'aspect important étant que le nombre de niveaux en azimut est défini selon l'invention.

Selon l'invention, le nombre de points par niveau ($N_\theta(i)$) est déterminé en fonction de deux valeurs de cardinalité cumulative successives (*cumN*(i), *cumN*(i - 1)), la valeur de cardinalité cumulative (*cumN*(i)) pour un indice d'élévation codée (i) étant représentative d'un nombre de points proportionnel à un nombre total de points et selon l'aire d'une zone sphérique comprenant au moins une zone délimitée par le plan horizontal supérieur ( $\phi = (i + \frac{1}{2})\delta_\phi$ ) du niveau d'élévation positive donné (i) et un plan horizontal inférieur (par exemple $\phi = \delta_\phi$/2). Dans le mode de réalisation privilégié cette zone sphérique comprend également la partie symétrique dans l'hémisphère Sud comprenant une zone délimitée par le plan horizontal supérieur ( $\phi = -(i + \frac{1}{2})\delta_\phi$ ) du niveau d'élévation donné (i) et un plan horizontal inférieur ($\phi$ = -$\delta_\phi$/2). La notation *cumN*(i) est reprise ici mais elle ne doit pas être confondue avec celle utilisée précédemment dans la description de l'état de l'art.

La figure 5b illustre ces zones sphériques pour lesquelles l'aire à la surface de la sphère 3D est prise en compte dans un premier et un deuxième mode de réalisation.

Dans un mode de réalisation particulier, le nombre de niveaux $N_\theta(i)$ en azimut est déterminé par des valeurs prédéfinies pour $N_\theta(0)$ et $N_\theta(N_\phi - 1)$ qui correspondent à l'équateur et à un des pôles, respectivement.

Ces nombres de points prédéterminés ($N_\theta(0)$ et $N_\theta(N_\phi - 1)$) sont pris en compte dans la détermination des valeurs de cardinalité cumulative et pour définir le nombre total $N'_{tot}$ de points, utilisé pour cette détermination.

Dans ce mode de réalisation, le nombre total de points ($N'_{tot}$) est obtenu en soustrayant à un nombre de points cible ($N_{tot} = 2^{16}$) le nombre de points prédéterminé correspondant à l'équateur et chacun des pôles nord et sud de la sphère selon l'expression suivante: $N'_{tot} = N_{tot} - N_\theta(0) - 2N_\theta(N_\phi - 1)$, $N_{tot}$ étant le nombre de points cible de la sphère pour un budget de bits donné, $N_\theta(0)$, le nombre de points prédéterminé pour le niveau d'élévation correspondant à l'équateur et $2N_\theta(N_\phi - 1)$ le nombre de points prédéterminé pour les pôles nord et sud de la sphère.

Dans le mode de réalisation principal, $N_\theta(0)$ est une valeur paire, $N_\theta(N_\phi - 1) = 1$ donc lorsque $N_{tot}$ est pair, $N'_{tot}$ est aussi pair.

Dans un exemple illustré à la figure 5b, l'aire d'une zone sphérique délimitée par le plan horizontal supérieur ($\phi = (i + \frac{1}{2})\delta_\phi$) du niveau d'élévation positive donné (i) et ce même plan de la sphère symétrique par rapport à l'équateur ($\phi = -(i + \frac{1}{2})\delta_\phi$) est illustrée par la zone hachurée A$_i$. A cette aire, il est retranché l'aire correspondant au niveau d'élévation de l'équateur, représentée en A$_0$, afin de déterminer la valeur de cardinalité cumulative ($cumN(i)$) du niveau d'élévation positive donné (i).

Pour cela, une estimation d'un nombre de points fonction du ratio $(A_i - A_0)/(A_{N_\phi-2} - A_0)$ est effectuée. Ce nombre de points est proportionnel au nombre total de points $N'_{tot}$ exprimé ci-dessus, selon le rapport suivant :

$$\frac{(A_i - A_0)}{\left(A_{N_\phi-2} - A_0\right)} N_{tot}{}'$$

Par construction, ce rapport donne exactement $N_{tot}'$ lorsque $i = N_\phi - 2$ ce qui garantit que le nombre de point total est complètement utilisé.

Comme ce rapport est en général un nombre fractionnaire, on devra l'arrondir pour obtenir la cardinalité cumulative, et comme le nombre de points est déterminé dans le mode de réalisation principal à la fois pour les hémisphères Nord et Sud (donc en double), l'arrondi sera dans ce cas à un entier pair (le plus proche, inférieur ou supérieur).

On rappelle que la surface d'un élément autour du point $(\theta, \phi)$ sur la sphère $\mathbb{S}_2$ est donnée par $dA = r^2 \cos \phi \, d\theta d\phi$ où $\phi$ est ici l'élévation (si la colatitude était utilisée, on aurait un terme en $\sin \phi$). La surface partielle définie par une zone sphérique délimitée par deux plans horizontaux induits par un intervalle d'élévation $[\phi_{min}, \phi_{max}]$, où $-90° \leq \phi_{min} < \phi_{max} \leq 90°$, l'azimut étant sur $[-180°, 180°]$, est donnée par:

$$A(\phi_{min}, \phi_{max}) = r^2 \int_{-180°}^{180°} d\theta \int_{\phi_{min}}^{\phi_{max}} \cos \phi \, d\phi = 2\pi r^2 (\sin \phi_{max} - \sin \phi_{min})$$

On retrouve en particulier le résultat connu que la surface de la sphère $\mathbb{S}_2$ de rayon r est $A_{tot} = A(-90°, 90°) = 4\pi r^2$ (pour $\phi_{min} = -90°$ et $\phi_{max} = 90°$).

Pour un nombre de points $N_{tot}'$ dans la grille sphérique (ou dictionnaire de quantification vectorielle sphérique) restant à distribuer dans une zone sphérique (sous-ensemble de la surface de la sphère 3D) délimitée par les plans horizontaux $\phi = -(N_\phi - 2 + \frac{1}{2})\delta_\phi$ en dehors de la zone centrale correspondant à l'équateur ($\phi = \pm\frac{\delta_\phi}{2}$), chaque « région de décision » associée à un point de la grille est ici approximée par un « rectangle sphérique » à des fins d'indexation (ce qui correspond à une décision de codage séparée des coordonnées sphériques). Chacune de ces régions doit idéalement avoir une surface de $4\pi r^2/N_{tot}'$ si la grille est uniforme.

Pour une discrétisation uniforme de l'élévation sur l'intervalle $[-(N_\phi - 2)\delta_\phi, (N_\phi - 2)\delta_\phi]$ comme dans le mode de réalisation principal, on peut donc estimer le nombre de points sur la grille compris dans une zone sphérique (ou « tranche sphérique ») délimitée par deux plans horizontaux associés aux seuils de décision $\phi_{min} = \frac{\delta_\phi}{2}$ et $\phi_{max} = (i + \frac{1}{2})\delta_\phi$

de la partie positive (hémisphère Nord) de la sphère.

Selon le rapport (ou ratio) exprimé ci-dessus, exprimant une simple règle de trois $\frac{(A_i - A_0)}{\left(A_{N_\phi - 2} - A_0\right)} N_{tot}{}'$, on peut

exprimer $\frac{(A_i - A_0)}{2} = A\left(\phi_{min}, \phi_{max}\right)$ avec $\phi_{min} = \frac{\delta_\phi}{2}$ et $\phi_{max} = \left(i + \frac{1}{2}\right)\delta_\phi$, et avec

$$A\left(\frac{\delta_\phi}{2}, \left(i + \frac{1}{2}\right)\delta_\phi\right) = 2\pi r^2 \left(\sin\left(i + \frac{1}{2}\right)\delta_\phi - \sin\frac{\delta_\phi}{2}\right)$$

Dans un exemple de réalisation, on fixe

$$N_\theta(0) = 430$$

Dans des variantes, la valeur de $N_\theta(0)$ pourra être différente mais paire.
De plus, par convention on fixe $N_\theta(N_\phi - 1) = 1$ car un seul point suffit à représenter un pôle.
On exprime le nombre de points par niveau d'élévation i par :

$$N_\theta(i) = \frac{\left(cumN(i) - cumN(i - 1)\right)}{2}$$

où

$$cumN(0) = 0$$

$$cumN(i) = 2Arr_i\left(\frac{N'_{tot}}{2} \frac{\sin\left((i + \frac{1}{2})\delta_\phi\right) - \sin\left(\frac{\delta_\phi}{2}\right)}{\sin\left((N_\phi - \frac{1}{2})\delta_\phi\right) - \sin\left(\frac{\delta_\phi}{2}\right)}\right)$$

$$\text{pour } i = 1, \dots, N_\phi - 2$$

avec $N'_{tot} = N_{tot} - N_\theta(0) - 2N_\theta\left(N_\phi - 1\right)$ et $Arr_i()$ est un arrondi à l'entier (le plus proche, inférieur ou supérieur) dépendant de i. Dans le mode de réalisation privilégié, on prend $Arr_1()$ comme l'arrondi à l'entier supérieur, et $Arr_i()$ comme l'arrondi à l'entier le plus proche pour i = 2, ..., $N_\phi$ - 2.
On notera que la fonction $2Arr_i(x/2)$ correspond en fait à un arrondi à un entier pair (plus proche, inférieur ou supérieur), ce qui permet de diviser le résultat par deux pour attribuer la moitié entière à chacun des hémisphères.
On remarquera que par définition $cumN\left(N_\phi - 2\right) = 2Arr_i\left(\frac{N'_{tot}}{2}\right) = N'_{tot}$.

De plus, on notera que la notation $cumN(i)$ est ici reprise bien qu'elle soit différente de celle utilisée précédemment dans la description d'un format MASA proposé dans l'état de l'art. En effet, ici $cumN(i)$ correspond à la cardinalité cumulative de la grille sphérique jusqu'à la couche d'élévation i incluse (avec les couches dans les hémisphères Nord et Sud) mais sans compter l'équateur. La définition de $cumN(i)$ pour i = 1, ... ,$N_\phi$ - 2 dans la description de l'invention correspond donc à l'équivalent de $cumN(2i) - N_\theta(0)$ dans la définition de l'état de l'art.
Dans des variantes où d'autres niveaux de quantification sont définis pour l'élévation, la définition de $cumN(i)$ en

fonction de sin ( $(i + \frac{1}{2})\delta_\phi$ ), i = 0, ..., $N_\phi$ - 2, sera adaptée en remplaçant $(i + \frac{1}{2})\delta_\phi$ par d'autres seuils de décision correspondants sous la forme $\frac{\hat{\phi}(i) + \hat{\phi}(i+1)}{2}$. Ainsi de façon plus générale on pourra écrire :

$$cumN(i) = 2Arr_i \left( \frac{N'_{tot}}{2} \frac{\sin\left(\frac{\hat{\phi}(i) + \hat{\phi}(i+1)}{2}\right) - \sin\left(\frac{\hat{\phi}(0) + \hat{\phi}(1)}{2}\right)}{\sin\left(\frac{\hat{\phi}(N_\phi - 2) + \hat{\phi}(N_\phi - 1)}{2}\right) - \sin\left(\frac{\hat{\phi}(0) + \hat{\phi}(1)}{2}\right)} \right)$$

pour $i = 1, \dots, N_\phi - 2$.

On donne ci-dessous un exemple de valeurs obtenues pour le mode de réalisation privilégié :

$$N_\theta(i = 0, \dots, 121) =$$

[ 430  423  422  422  422  422  421  421  420  420  419  418  417  417

  416  414  414  412  412  409  409  407  406  404  402  401  399  397

  395  394  391  389  387  385  383  380  378  375  373  370  368  365

  362  359  356  354  350  347  344  341  338  334  331  328  324  321

  317  313  310  306  302  299  294  291  287  282  279  274  270  266

  262  258  253  249  244  240  235  231  226  222  217  212  208  202

  198  194  188  183  179  173  169  163  159  153  148  144  138  133

  127  123  117  112  107  102  96  91  85  81  75  69  64  59

  53  48  43  37  32  26  21  15  10  1]

On peut facilement vérifier que :

$N_\theta(0) + 2 \sum_{i=1}^{N_\phi - 1} N_\theta(i) = 65536$   ce qui correspond bien à $N_{tot}$.

Ainsi, la cardinalité $N_\theta(i)$ selon l'invention permet de garantir qu'il n'y ait aucun indice inutilisé pour un nombre total $N_{tot}$ donné. Cette propriété découle du fait que la cardinalité cumulative $cumN(i)$ est définie de telle sorte que $cumN(N_\phi - 2) = N'_{tot}$ .

Dans un autre exemple de réalisation, on ne fixe pas de nombres prédéterminés pour les niveaux d'élévation correspondant à l'équateur.

Dans ce cas, la valeur de cardinalité cumulative est une valeur arrondie du rapport suivant :

$$\frac{A_i}{A_{N_\phi - 2}} (N_{tot} - 2)$$

avec par exemple $N_{tot} = 2^{16}$.

On obtient alors (en dehors des pôles)

$$cumN(i) = 2Arr_i \left( \frac{N_{tot} - 2}{2} \frac{\sin\left((i + \frac{1}{2})\delta_\phi\right)}{\sin\left((N_\phi - \frac{3}{2})\delta_\phi\right)} \right)$$

pour $i = 0, \dots, N_\phi - 2$. Dans ce cas, on a : $N_\theta(0) = cumN(0)$
et

$$N_\theta(i) = \frac{\left(cumN(i) - cumN(i-1)\right)}{2}$$

pour $i = 1, \dots, N_\phi - 2$. On fixe également $N_\theta(N_\phi - 1) = 1$.

On donne ci-dessous un exemple de valeurs obtenues pour cette variante de définition de $cumN(i)$ dans le cas où $N_\phi = 122$ et $\delta_\phi$ est défini selon le mode de réalisation privilégié:

$$N_\theta(i = 0, \dots, 121) =$$

$$
\begin{aligned}
[ \ & 422 \ 423 \ 422 \ 423 \ 422 \ 421 \ 422 \ 420 \ 421 \ 419 \ 419 \ 419 \ 417 \ 417 \\
& 416 \ 414 \ 414 \ 412 \ 412 \ 410 \ 408 \ 407 \ 406 \ 404 \ 403 \ 400 \ 400 \ 397 \\
& 395 \ 393 \ 392 \ 389 \ 387 \ 385 \ 383 \ 380 \ 378 \ 375 \ 373 \ 370 \ 368 \ 365 \\
& 362 \ 359 \ 356 \ 354 \ 350 \ 348 \ 344 \ 341 \ 337 \ 335 \ 331 \ 328 \ 324 \ 321 \\
& 317 \ 313 \ 310 \ 306 \ 302 \ 299 \ 294 \ 291 \ 287 \ 282 \ 279 \ 274 \ 271 \ 266 \\
& 261 \ 258 \ 253 \ 249 \ 244 \ 240 \ 236 \ 230 \ 227 \ 221 \ 217 \ 213 \ 207 \ 203 \\
& 198 \ 193 \ 188 \ 184 \ 178 \ 174 \ 168 \ 164 \ 158 \ 154 \ 148 \ 144 \ 138 \ 133 \\
& 127 \ 123 \ 117 \ 112 \ 107 \ 102 \ 96 \ 91 \ 85 \ 81 \ 75 \ 69 \ 64 \ 59 \\
& 53 \ 48 \ 43 \ 37 \ 32 \ 26 \ 21 \ 15 \ 10 \ 1]
\end{aligned}
$$

On peut facilement vérifier que là encore:

$$N_\theta(0) + 2 \sum_{i=1}^{N_\phi - 1} N_\theta(i) = 65536$$

ce qui correspond bien à $N_{tot}$.

Dans des variantes où d'autres niveaux de quantification sont définis pour l'élévation, la définition de *cumN(i)* en fonction de sin ( $(i + \frac{1}{2})\delta_\phi$ ) ,*i = 0, ..., $N_\phi$ - 2*, sera adaptée en remplaçant $(i + \frac{1}{2})\delta_\phi$ par d'autres seuils de décision correspondants sous la forme $\frac{\hat{\phi}(i) + \hat{\phi}(i+1)}{2}$ .

Dans d'autres variantes, on ne fixe pas de nombres prédéterminés pour les niveaux d'élévation correspondant à l'équateur ($N_\theta(0)$) ni aux pôles Nord et Sud ($N_\theta(N_\phi$ - 1)). Cette variante s'applique particulièrement au cas où la quantification scalaire de $\phi$ est uniforme sur l'intervalle [0,90] degrés (en incluant les valeurs 0 et 90 comme niveaux de reconstruction) avec :

$$\hat{\phi}(i) = \frac{i}{N_\phi - 1} 90, \qquad i = 0, \dots, N_\phi - 1$$

avec $\delta_\phi = 90/N_\phi$-1.

Dans ce cas, on peut définir :

$$cumN(i) = 2 Arr_i \left( \frac{N_{tot}}{2} \sin\left( (i + \frac{1}{2})\delta_\phi \right) \right)$$

pour i = 0, ... , $N_\phi$ - 2, et

$$cumN(N_\phi - 1) = N_{tot}$$

on a :

$$N_\theta(0) = cumN(0)$$

et

$$N_\theta(i) = \frac{\left( cumN(i) - cumN(i - 1) \right)}{2}$$

pour i = 1, ..., $N_\phi$ - 1.

On donne ci-dessous un exemple de valeurs obtenues pour cette variante de définition de *cumN(i)* dans le cas où $N_\phi$ = 122 et $\delta_\phi$ est défini selon le mode de réalisation privilégié:

$$N_\theta\,(i = 0, \dots ,121) =$$

[ 426 425 425 425 425 425 424 423 423 423 422 421 420 419

419 417 416 415 414 413 411 410 408 406 405 403 402 399

398 395 394 391 390 387 384 382 380 377 375 372 369 367

364 360 358 355 352 349 345 342 339 336 332 328 325 322

318 314 310 307 302 299 295 291 287 283 278 275 270 266

261 257 253 248 244 239 235 230 225 221 215 212 206 201

197 191 187 182 177 171 167 161 157 151 146 141 136 130

125 120 114 110 104 98 93 88 82 77 72 66 60 55

50 44 38 34 27 22 17 11 5 1]

On peut facilement vérifier que là encore:

$$N_\theta(0) + 2 \sum_{i=1}^{N_\phi-1} N_\theta(i) = 65536$$

ce qui correspond bien à $N_{tot}$.

Dans un deuxième exemple illustré à la figure 5b, l'aire d'une zone sphérique délimitée par le plan horizontal supérieur ( $\phi = (i + \frac{1}{2})\delta_\phi$ ) du niveau d'élévation positive donné (i) et celui de l'équateur est illustrée par la zone notée A'i. A cette aire, il est retranché la moitié de l'aire correspondant au niveau d'élévation de l'équateur, représentée en A0, afin de déterminer la valeur de cardinalité cumulative (*cumN(i)*) du niveau d'élévation positive donné (i).

Pour cela, une estimation d'un nombre de points fonction du ratio $(A'_i - A_0/2)/ (A'_{N_\phi-2} - A_0/2)$ est effectuée. Ce nombre de points est proportionnel au nombre total de points $N'_{tot}$ exprimé ci-dessus, selon le rapport suivant :

$$\frac{A'_i - A_0/2}{A'_{N_\phi-2} - A_0/2} N_{tot}' \; ,$$

avec $A'_{N_\phi-2}$ l'aire de la zone sphérique délimitée par le plan horizontal supérieur ($\phi = ( N_\phi - \frac{1}{2})\delta_\phi$ ) du niveau d'élévation positive $N_\phi$ - 2 et celui de l'équateur.

Le résultat est équivalent à ce qui a été décrit précédemment car

$$\frac{A'_i - A_0/2}{A'_{N_\phi-2} - A_0/2} = \frac{2A'_i - A_0}{2A'_{N_\phi-2} - A_0} = \frac{A_i - A_0}{A_{N_\phi-2} - A_0}$$

Dans une variante de réalisation, la valeur de cardinalité cumulative peut s'exprimer en ne prenant en compte que le nombre de points de la partie positive de la sphère. Dans ce cas de figure, une estimation d'un nombre de points fonction du ratio $(A'_i - A_0/2)/ (A'_{N_\phi-2} - A_0/2)$ est effectuée. Ce nombre de points est proportionnel au nombre total de points $N'_{tot}$ exprimé ci-dessus, selon le rapport suivant :

$$\frac{(A'_i - A_0/2)}{\left(A'_{N_\phi-2} - A_0/2\right)} \frac{N'_{tot}}{2}$$

L'expression de la valeur de cardinalité cumulative est donné par exemple par :

$$cumN'(i) = Arr_i \left( \frac{N'_{tot}}{2} \frac{\sin\left((i+\frac{1}{2})\delta_\phi\right) - \sin\left(\frac{\delta_\phi}{2}\right)}{\sin\left((N_\phi - \frac{1}{2})\delta_\phi\right) - \sin\left(\frac{\delta_\phi}{2}\right)} \right)$$

pour $i = 1, \dots, N_\phi - 2$

avec $N'_{tot} = N_{tot} - N_\theta(0) - 2N_\theta(N_\phi - 1)$

Et $Arr_i()$ est un arrondi à l'entier le plus proche dépendant de i. Dans le mode de réalisation privilégié, on prend $Arr_1()$ comme l'arrondi à l'entier supérieur, et $Arr_i()$ comme l'arrondi à l'entier le plus proche pour i = 2, ..., $N_\phi$ - 2.

Et on exprime le nombre de points par niveau d'élévation i par :

$$N_\theta(i) = \left( cumN'(i) - cumN'(i-1) \right)$$

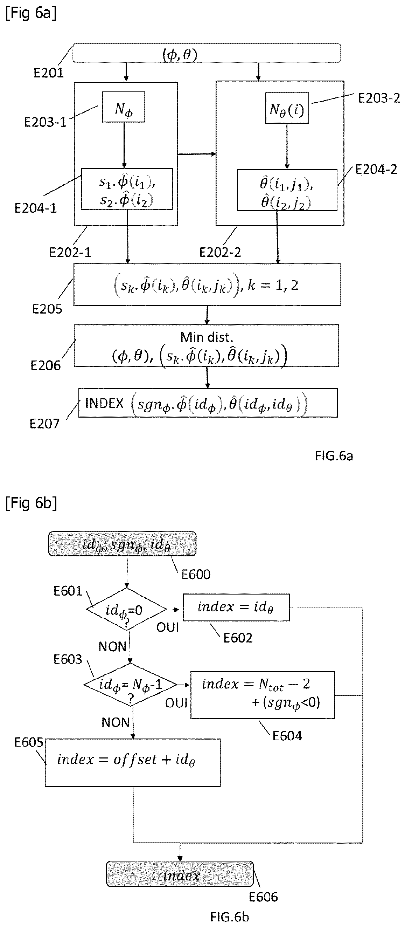

La **figure 6a** décrit un procédé de codage des coordonnées sphériques $(\phi, \theta)$ d'un point d'entrée (E201) sur une sphère 3D. Ce procédé de codage peut être mis en œuvre, dans un mode de réalisation, par le bloc 312 de la figure 3 pour le format de donnée MASA ou dans le bloc 140 de la figure 1 pour un codeur DirAC.

La quantification des coordonnées sphériques et la recherche s'effectue comme suit :

- On code d'abord l'élévation $\phi$ en E202-1. Pour que la recherche soit optimale, il convient de retenir les 2 valeurs $sgn_\phi \cdot \phi$ ($i_1$), $sgn_\phi \cdot \hat{\phi}(i_2)$ où $sgn_\phi$ est le signe de $\phi$ et $\hat{\phi}(i_k)$ est l'élévation absolue codée, où $k = 1$ ou 2. Ce codage peut être effectué par une recherche des 2 plus proches voisins dans le dictionnaire d'élévation de $N_\phi$ niveaux déterminé (E203-1). De façon préférentielle, on remplacera la recherche exhaustive dans le dictionnaire scalaire d'élévation par une détermination directe de l'indice d'élévation $i_1$ par un arrondi :

$$i_1 = \min\left( \left\lceil \frac{|\phi|}{\delta_\phi} \right\rceil, N_\phi - 1 \right)$$

$$i_1 \leftarrow \arg\min_{i = N_\phi - 1, N_\phi - 2} \left| |\phi| - \hat{\phi}(i) \right|, \text{ si } i_1 \geq N_\phi - 1$$

La dernière étape est nécessaire ici car dans le mode de réalisation privilégié on prend : $\hat{\phi}(i) = i\delta_\phi$ pour i = 0, ..., $N_\phi$ - 2 et $\hat{\phi}(i) = 90$ pour i = $N_\phi$ - 1 Ainsi le pas de quantification est uniforme uniquement sur l'intervalle $[-(N_\phi - 2)\delta_\phi, (N_\phi - 2)\delta_\phi]$. Pour les mots de code d'indice i = $N_\phi$ - 1, $N_\phi$ - 2 une recherche du plus proche voisin explicite est requise.

Dans des variantes, où le pas est uniforme sur [-90, 90] degrés, on pourra prendre :

$$i_1 = \left\lceil \frac{|\phi|}{\delta_\phi} \right\rceil$$

**Avec** $\delta_\phi$ = 90/($N_\phi$ - 1), sachant que :

$$\hat{\phi}(i) = \frac{i}{N_\phi - 1} 90, \qquad i = 0, \dots, N_\phi - 1$$

La détermination de l'indice $i_2$ peut être effectuée comme décrit précédemment dans la méthode MASA de l'état de l'art, à savoir :

- $i_2 = 1$ si $i_1$=0
- $i_2 = N_\phi$ - 2 si $i_1$= $N_\phi$ - 1
- $i_2 = \arg\min_{i = i_1 - 1, i_1 + 1} \left| |\phi| - \hat{\phi}(i) \right|$ si 0 < $i_1$ < $N_\phi$-1

On note dans tous les cas que les valeurs $i_1$ et $i_2$ peuvent être interchangées sans que cela change le résultat du codage.

On code l'azimut $\theta$ par quantification scalaire uniforme en E204-2 avec un nombre de niveaux adaptatif $N_\theta(i)$ où $i = i_1$ ou $i_2$, déterminés selon les exemples de réalisation décrits dans la méthode MASA de l'état de l'art (E203-2), pour obtenir en E204-2, les deux valeurs $\hat{\theta}(i_1,j_1)$, $\hat{\theta}(i_2,j_2)$ respectivement. Plus précisément on peut prendre :

$$j_k = mod_{N_\theta(i_k)} \left\lfloor \frac{\theta - \Delta + 180/N_\theta(i_k)}{360/N_\theta(i_k)} \right\rfloor$$

On obtient donc à l'étape E205, deux candidats $(sgn_\phi \cdot \hat{\phi}(i_k), \hat{\theta}(i_k,i_k))$.

- A l'étape E206, on sélectionne le candidat le plus proche $(\phi, \theta)$ en fonction de $k$ par exemple comme dans la méthode MASA de l'état de l'art.

$$d(i_k, s_k, j_k) = -(\sin\phi \sin\hat{\phi}(i_k) + \cos\phi \cos\hat{\phi}(i_k) \cos(\theta - \hat{\theta}(i_k,j_k)))$$

La paire $(sgn_\phi \cdot \hat{\phi}(i_k), \hat{\theta}(i_k,j_k))$ la plus proche est sélectionnée comme valeur quantifiée à indexer. On note ce point sélectionné $(sgn_\phi \cdot \phi(id_4), \hat{\theta}(id_\phi, id_\theta))$. Dans des variantes, le critère de distance peut être évalué en convertissant les points en coordonnées cartésiennes pour évaluer la distance euclidienne qui est à minimiser ou le produit scalaire qui est à maximiser.

Les indices de quantification sélectionnés en E206 correspondent au point sélectionné :

$$\left( sgn_\phi \cdot \hat{\phi}(id_\phi), \hat{\theta}(id_\phi, id_\theta) \right).$$

L'étape d'indexation E207 consiste, à partir des informations $sgn_\phi$, $id_\phi$ et $id_\theta$, à déterminer un indice unique $0 \le index < N_{tot}$ à transmettre.

On détermine à cette étape un indice de quantification global en fonction des indices séparés issus de la quantification séparée des coordonnées sphériques pour le point le plus proche sélectionné.

Cette étape est maintenant décrite en référence à la **figure 6b** montrant un exemple de réalisation.

A partir des informations $sgn_\phi$, $id_\phi$ et $id_\theta$, en E600, on teste en E601 et E603, la valeur de $id_\phi$.

si $id_\phi = 0$ en E601, alors $index = id_\theta$ (E602)
ou
si $id_\phi = N_\phi - 1$ en E603, alors $index = N_{tot} - 2 + (sgn_\phi < 0)$ (E604)

Dans les autres cas,

$index = offset + id_\theta$ (E605)
Avec

$$offset = N_\theta(0) + 2 Arr_{id_\phi}\left( \frac{N'_{tot}}{2} \frac{\sin\left(\left(id_\phi + \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)} \right)$$

$$- \begin{cases} 2N_\theta(id_\phi) & si\ sgn_\phi > 0 \\ N_\theta(id_\phi) & si\ sgn_\phi < 0 \end{cases}$$

On rappelle ici que le terme

$$N_\theta(0) + 2 Arr_{id_\phi}\left( \frac{N'_{tot}}{2} \frac{\sin\left(\left(id_\phi + \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)} \right)$$

correspond à la cardinalité cumulative de la grille sphérique jusqu'à la couche d'élévation i incluse (avec les couches dans les hémisphères Nord et Sud, et avec l'équateur).

L'indice d'un point (mot de code) dans la couche d'élévation i étant de la forme :

$$index = offset + id_\theta$$

il faut donc que la valeur de *offset* corresponde à la cardinalité cumulative jusqu'au premier point (mode de code) - exclus - de la couche d'élévation i. De plus, la couche d'élévation i positive (hémisphère Nord) vient par convention avant la couche d'élévation i négative, mais ces deux couches ont le même nombre de points $N_\theta(i)$.

Ainsi, la valeur *offset* est donnée par la cardinalité cumulative incluant ces couches positives et négatives d'indice i, mais en retranchant soit $2N_\theta(i)$ quand il s'agit de la couche positive, soit $N_\theta(i)$ quand il s'agit de la couche négative.

Pour le codage d'un point (ou mot de code) dans cette même couche, on peut de façon équivalente définir :

$$offset = N_\theta(0) + 2Arr_{id_\phi}\left(\frac{N'_{tot}}{2}\frac{\sin\left(\left(id_\phi - \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)}\right)$$

$$+ \begin{cases} 0 & si\ sgn_\phi > 0 \\ N_\theta\left(id_\phi\right) & si\ sgn_\phi < 0 \end{cases}$$

Ici le terme $N_\theta(0) + 2Arr_{id_\phi}\left(\frac{N'_{tot}}{2}\frac{\sin\left(\left(id_\phi - \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)}\right)$ donne la cardinalité cumulative jusqu'à la couche d'élévation d'indice i-1. Cette valeur correspond directement à la valeur *offset* pour la couche d'élévation positive d'indice i, et elle doit être corrigée de $N_\theta(id_\phi)$ pour la couche négative d'indice i.

Selon l'invention, cette méthode analytique de détermination de la valeur *offset* donne le même résultat que la somme suivante, mais à complexité réduite car la détermination est plus directe quand $N_\phi$ est élévé (par exemple $N_\phi$ =122):

$$offset = N_\theta(0) + 2\sum_{i=1}^{id_\phi-1} N_\theta(i) - \begin{cases} 2N_\theta\left(id_\phi\right) & si\ sgn_\phi > 0 \\ N_\theta\left(id_\phi\right) & si\ sgn_\phi < 0 \end{cases}$$

et

$$offset = N_\theta(0) + 2\sum_{i=1}^{id_\phi-2} N_\theta(i) + \begin{cases} 0 & si\ sgn_\phi > 0 \\ N_\theta\left(id_\phi\right) & si\ sgn_\phi < 0 \end{cases}$$

Ainsi l'indice global *index* est obtenu en E606, par codage séparé des indices de quantification séparés $sgn_\phi$, $id_\phi$ et $id_\theta$ du meilleur candidat et par l'utilisation des valeurs de cardinalité cumulatives correspondantes.

On notera que la détermination de la valeur *offset* est décrite ici pour l'intervalle $N_\theta(0) \leq index < N_{tot}$ - 2. Dans des variantes, on pourra découper l'intervalle en question en sous-intervalles d'indices, et déterminer la valeur de *offset* soit de façon analytique soit par somme directe, avec $N_\theta(i)$ défini selon l'invention, en fonction du sous-intervalle considéré.

Dans un mode de réalisation, on pourra utiliser un pré-stockage (tabulation) des valeurs de cardinalité cumulatives *offset* en fonction de $id_\phi$ et $sgn_\phi$ qui donne (de façon analytique ou par somme directe) le résultat de la somme cumulative de cardinalités de couches (ou « ensembles de tranches horizontales ») sphériques successives. Cette somme peut s'interpréter comme la cardinalité d'une zone sphérique (le nombre de points de la grille partielle allant de l'élévation d'indice 0 à l'élévation d'indice *i*, en alternant entre hémisphère Nord et Sud).

Dans des variantes on pourra ne pas stocker les valeurs *offset* en fonction de $id_\phi$ et $sgn_\phi$ mais les calculer « en ligne » (au fil de l'eau) à partir de la définition de *offset* comme la somme cumulative de $N_\theta(i)$ avec la correction en fonction de $id_\phi$ et $sgn_\phi$. Cela rajoute cependant une complexité de calcul qui peut être non négligeable si la grille comprend beaucoup de niveaux d'élévation ($N_\phi$ élévé).

Dans des variantes, on pourra remplacer *offset* en utilisant la définition de cumN' et en prenant compte du fait que la cardinalité dans ce cas correspond à un hémisphère.

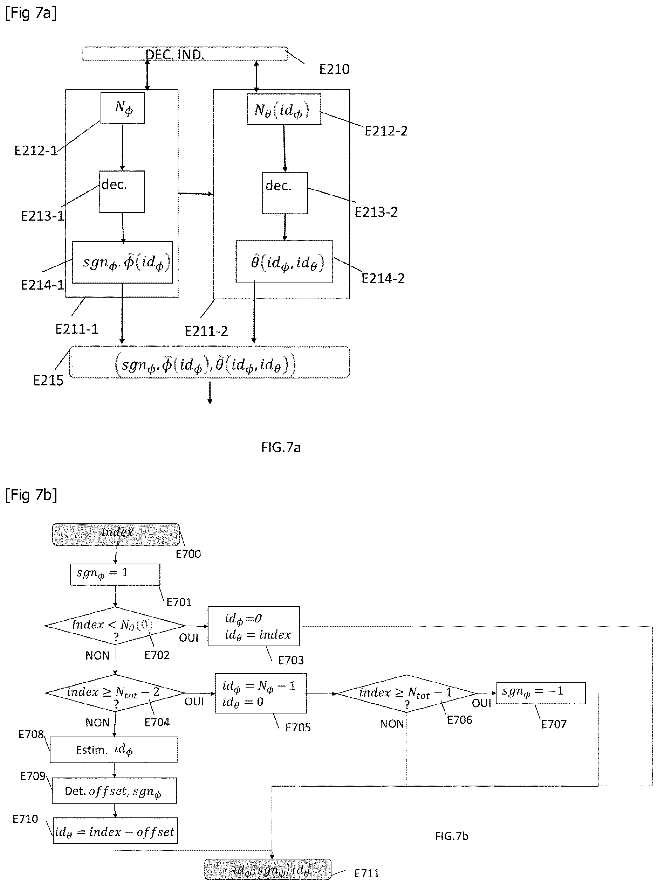

Le procédé de décodage correspondant, est maintenant décrit en référence à la **figure 7a.** Ce procédé de décodage peut être mis en œuvre, dans un mode de réalisation, par le bloc 321 de la figure 3, pour le format de donnée MASA ou dans le bloc 250 de la figure 2 pour un décodeur DirAC.

Comme pour le codage, le dictionnaire de quantification sphérique est défini sur une sphère 3D par un décodage de l'élévation et de l'azimut. Ce dictionnaire de quantification sphérique est illustré et décrit en référence aux figures 5a et 5b ci-dessus.

De la même façon que pour le codage, le décodage de l'élévation utilise une quantification scalaire, donnant au moins un indice d'élévation décodée (i) sur un nombre de niveau ($N_\phi$) d'élévation , le décodage de l'azimut utilise une quantification scalaire, en fonction d'un nombre de points par niveau ($N_\theta(i)$) dépendant de l'indice de l'élévation décodée (i), le nombre de points par niveau ($N_\theta(i)$) est déterminé en fonction de deux valeurs de cardinalité cumulative successives (cumN(i), cumN(i - 1)), la valeur de cardinalité cumulative (cumN(i)) pour un indice d'élévation décodée (i) étant représentative d'un nombre de points proportionnel à un nombre total de points et selon l'aire d'une zone sphérique comprenant au moins une zone délimitée par le plan horizontal supérieur ( $\phi = (i + \frac{1}{2})\delta_\phi$ ) du niveau d'élévation positive de l'indice d'élévation décodée (i) et un plan horizontal inférieur de la sphère.

On suppose d'abord une indexation décrite en référence à la figure 6b.

Etant donné l'indice global *index* à l'étape E210 de la figure 7a, on effectue un décodage séparé des deux coordonnées sphériques aux étapes E211-1 et E211-2.

A l'étape E212-1, on détermine comme à l'étape de codage E203-1 un nombre de niveaux de quantification scalaire $N_\phi$. Dans le mode de réalisation principal, cette étape revient simplement à fixer $N_\phi$ = 122.

Le décodage des informations d'élévation $sgn_\phi$, $id_\phi$ se retrouve en E213-1. Cette étape est détaillée plus loin en référence à la figure 7b. De façon préférentielle, ce décodage utilise une estimation analytique de l'indice $id_\phi$. Dans des variantes, le décodage de $sgn_\phi$, $id_\phi$ peut s'effectuer par une recherche dans la table de cardinalité calculée au fil de l'eau ou stockée ou par d'autres méthodes donnant un résultat identique.

On reconstruit l'élévation décodée en E214-1 comme $sgn_\phi. \hat{\phi}(id_\phi)$ où

$$sgn_\phi. \hat{\phi}(i) = sgn_\phi. i\delta_\phi \text{ pour } i = 0, \dots, N_\phi - 2 \text{ et}$$

$$sgn_\phi. \hat{\phi}(i) = sgn_\phi. 90 \text{ pour } i = N_\phi - 1$$

Dans des variantes, d'autres dictionnaires de quantification uniforme ou non-uniforme $\{\hat{\phi}(i)\}$ seront possibles de façon identique au codage.

Le décodage de l'indice d'azimut $id_\theta$ se retrouve en E213-2. Cette étape est détaillée plus loin en référence à la figure 7b. L'indice $id_\theta$ de l'azimut est obtenu dans le cas général par soustraction selon la formule suivante : $id_\theta = index - offset$ à partir de l'indice global *index* et des informations d'élévation décodées $sgn_\phi$ et $id_\phi$, cependant des cas particuliers ($id_\phi$ = 0 et $id_\phi = N_\phi$ - 1) sont définis à la figure 7b.

On détermine la valeur du décalage comme défini au codage et on reconstruit l'azimut $\hat{\theta}(id_\phi, id_\theta)$ en E214-2 comme :

$$\hat{\theta}(i,j) = \begin{cases} 360 j/ N_\theta(i) - 180 & i \text{ paire} \\ 360 (j + 0.5)/ N_\theta(i) - 180 & i \text{ impaire} \end{cases}$$

On a en particulier $\hat{\theta}(id_\phi = N_\phi$ - 1, $id_\theta$ = 0) = -180 avec $N_\theta(id_\phi = N_\phi$ - 1) = 1.

On obtient ainsi les coordonnées sphériques ($\hat{\phi}(i), \hat{\theta}(i,j)$) du point décodé en E215.

Les étapes E213-1 et E213-2 sont détaillées conjointement à la **figure 7b.**

A partir de l'indice global 0 ≤ *index* < $N_{tot}$ à décoder (E700), on fixe par défaut l'information de signe $sgn_\phi$ = 1 (E701). Si l'indice vérifie *index* < $N_\theta(0)$, ce qui indique qu'il s'agit d'un point sur l'équateur (E702), on décode directement : $id_\theta$ = *index* et on fixe $id_\phi$ = 0 (E703).

Sinon, si l'indice vérifie *index* ≥ $N_{tot}$ - 2, ce qui indique qu'il s'agit d'un point sur le pôle Nord ou Sud (E704), on décode directement :
$id_\phi = N_\phi$ - 1, $id_\theta$ = 0 (E705). Le signe $sgn_\phi$ est corrigé de sa valeur par défaut à -1 (E707) si *index* = $N_{tot}$ - 1 en E706 car les indices sont ordonnés par couches d'élévation en alternant entre hémisphère Nord et hémisphère Sud, donc *index* = $N_{tot}$ - 2 correspond au pôle Nord ($sgn_\phi$ = 1) et *index* = $N_{tot}$ - 1 correspond au pôle Sud ($sgn_\phi$ = -1).

Sinon, dans les autres cas ($N_\theta(0)$ ≤ *index* < $N_{tot}$ - 2), dans un mode de réalisation privilégié l'estimation de l'indice $id_\phi$ est par exemple réalisée en inversant le calcul analytique fait à l'étape E605 de la figure 6b.

On pourra estimer $id_\phi$ comme :

$$id_\phi = \left\lceil \frac{1}{\delta_\phi} arcsin(x) \right\rceil$$

Où x =
$$x = \left(index - N_\theta(0) - 2 - \frac{1}{2}\right)\frac{2\left(\sin\left(\left(N_\phi - \frac{1}{2}\right)\delta_\phi\right) - \sin\left(\frac{\delta_\phi}{2}\right)\right)}{N'_{tot}} + \sin\left(\frac{\delta_\phi}{2}\right)$$
et [ . ] est l'arrondi à l'entier le plus proche

Dans des variantes, on utilise une approximation de la fonction arcsinus. On prend ainsi (en E708):

$$id_\phi = \left\lceil \frac{1}{\delta_\phi}\left(\frac{\pi}{2} - \sqrt{1-x}.P(x)\right) \right\rceil$$

où

$P(x) = 1.57078786 + x (-0.21412453 + x (0.08466649 + x (-0.03575663 + 0.00864884. x)))$

est un polynôme de degré 4.

Dans des variantes d'autres approximations de la fonction arcsinus pourront être utilisées, en particulier d'autres polynômes P(x) de degré différent pourront être utilisés. On remarquera que l'estimation de $id_\phi$ utilisée ci-dessus a pour propriété remarquable d'être exacte à une surestimation près de $id_\phi$ d'une unité - en général, elle donne la bonne valeur de $id_\phi$, si ce n'est pas le cas, $id_\phi$ est sous-estimé d'une unité.

Dans des variantes, d'autres estimations de $id_\phi$ (exactes ou à une valeur près) pourront être utilisées.

Dans le mode de réalisation privilégié le décodage (E709) s'effectue ensuite comme suit à partir de l'estimation de $id_\phi$ par inversion de la fonction arcsinus ou d'une approximation. On détermine une valeur initiale de :

$$offset_{init} = N_\theta(0) + 2Arr_{id_\phi}\left(\frac{N'_{tot}}{2}\frac{\sin\left(\left(id_\phi + \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)}\right)$$

Dans des variantes on pourra calculer de façon équivalente (avec le même résultat) :

$$offset_{init} = N_\theta(0) + 2\sum_{i=1}^{id_\phi} N_\theta(i)$$

A partir de cette valeur initiale $offset_{init}$ on peut ensuite déterminer les valeurs de $id_\phi$, $sgn_\phi$ et *offset* comme suit: Si *index* $\geq offset_{init}$, $id_\phi \leftarrow id_\phi + 1$, *offset* $\leftarrow offset_{init}$, sinon :

$$offset \leftarrow offset_{init} - N_\theta(id_\phi)$$

Si *index* $\geq$ *offset*: $sgn_\phi \leftarrow$ -1
Sinon : *offset* $\leftarrow$ *offset* - $N_\theta(id_\phi)$

Où $a \leftarrow b$ indique que la valeur existante de *a* est remplacée par le résultat de l'expression b.

L'étape de correction $id_\phi \leftarrow id_\phi + 1$ quand *index* $\geq offset_{init}$ est spécifique à l'exemple de réalisation de l'estimation de $id_\phi$ par inversion de la fonction arcsinus. Si cette étape est effectuée la valeur de $offset_{init}$ correspond à la cardinalité cumulative de la grille jusqu'à la couche inférieure $id_\phi$ - 1.

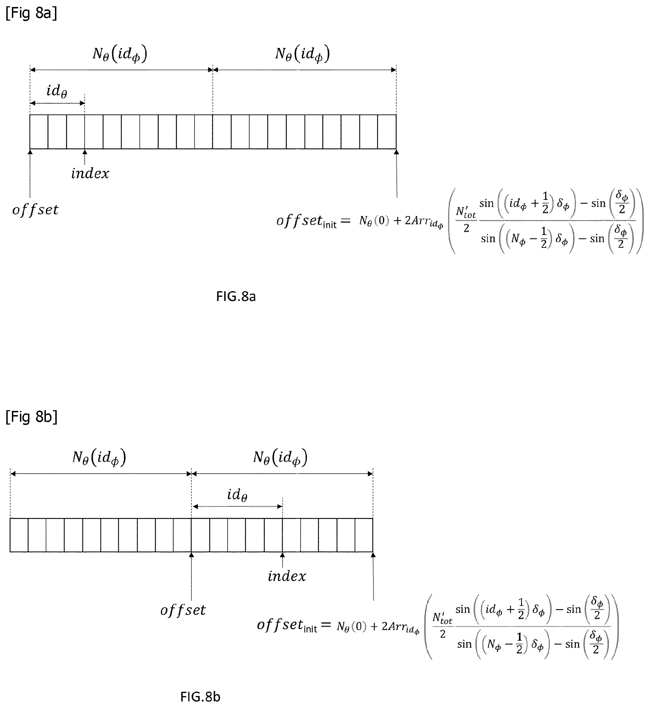

Dans le cas contraire, si cette étape de correction de $id_\phi$ n'est pas effectuée, la valeur de $offset_{init}$ correspond à la cardinalité cumulative de la grille jusqu'à la couche d'élévation $id_\phi$. la justification des étapes de correction de la valeur $offset_{init}$ sous la forme *offset* - $N_\theta(id_\phi)$ est détaillée en rapport aux figures 8a et 8b décrites plus loin.

Dans des variantes, on pourra définir comme valeur initiale $offset_{init}$ la cardinalité cumulative pour la couche d'élévation inférieur d'indice i-1 et corriger la valeur de $offset_{init}$ de façon équivalente. La valeur initiale est donnée par :

$$offset_{init} = N_\theta(0) + 2Arr_{id_\phi}\left(\frac{N'_{tot}}{2}\frac{\sin\left(\left(id_\phi - \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)}\right)$$

A partir de cette valeur initiale *offset*$_{init}$ on peut ensuite déterminer les valeurs de *id*$_\phi$, *sgn*$_\phi$ et *offset* comme suit: Si *index* ≥ *offset*$_{init}$ + 2$N_\theta$(*id*$_\phi$), *id*$_\phi$ ← *id*$_\phi$ + 1, *offset* ← *offset*$_{init}$, sinon :

Si *index* ≥ *offset*$_{init}$ + $N_\theta$(*id*$_\phi$): *sgn*$_\phi$ ← -1 et *offset* ← *offset*$_{init}$ + $N_\theta$ (*id*$_\phi$)
Sinon : *offset* ← *offset*$_{init}$,

Où *a* ← b indique que la valeur existante de *a* est remplacée par le résultat de l'expression b. Dans ce cas, les étapes de correction de la valeur *offset*$_{init}$ sont sous la forme *offset*$_{init}$ + $N_\theta$(*id*$_\phi$).

Dans des variantes on pourra adapter le principe de correction de la valeur de *id*$_\phi$ et de *offset*$_{init}$ en fonction de la méthode d'estimation de *id*$_\phi$, pour déterminer les valeurs de *id*$_\phi$, *sgn*$_\phi$ et *offset*.

Dans des variantes où la cardinalité cumulative est définie de façon différente, avec des valeurs $N_\theta(i)$ correspondantes, on adaptera la définition analytique de l'estimation initiale de *offset*.

Dans des variantes, d'autres estimations entières et exactes (donnant les mêmes résultats) de *id*$_\phi$ et d'autres méthodes directes ou indirectes de détermination de *id*$_\phi$, *sgn*$_\phi$ et de *offset* pourront être utilisées tant qu'elles ne changent pas le résultat de décodage. En effet, les valeurs de *id*$_\phi$ et *offset* étant entières, le signe *sgn*$_\phi$ pouvant être vu comme un entier signé, des méthodes alternatives peuvent être mises en œuvre tant qu'elles donnent des valeurs identiques pour *id*$_\phi$, *sgn*$_\phi$ et *offset*.

Un exemple de variante de décodage de *id*$_\phi$, *sgn*$_\phi$ et *offset* qui ne présente que peu d'intérêt mais qui a le mérite d'illustrer un exemple de méthode alternative consisterait à simplement parcourir de façon exhaustive toutes les valeurs possibles *id*$_\phi$, *sgn*$_\phi$ et *id*$_\phi$ et de calculer l'indice correspondant comme au codeur et de sélectionner la combinaison qui conduit exactement à *index* = *offset* + *id*$_\theta$.

Le décodage de l'indice est déterministe dans le sens où pour une valeur *index* donnée, les valeurs *id*$_\phi$, *sgn*$_\phi$ et *id*$_\phi$ sont uniques et entières.

Dans tous les cas le décodage de *id*$_\phi$, *sgn*$_\phi$ et *offset* s'appuie sur les valeurs de $N_\theta(i)$ selon l'invention avec la possibilité de déterminer de façon analytique une cardinalité cumulative.

Enfin, le décodage de *id*$_\theta$ (E710) revient simplement à retrancher la valeur de cardinalité cumulative décodé (*offset*) à l'indice global reçu (*index*):

$$id_\theta = index - offset$$

Dans des variantes, on pourra remplacer *offset* en utilisant la définition de cumN' et en prenant compte du fait que la cardinalité dans ce cas correspond à un hémisphère.

On a illustré sur les **figures 8a** et **8b,** le codage de l'indice, selon le mode de réalisation de l'invention, et le etdécodage de l'indice

La figure 8a correspond au cas d'un codage ou décodage d'un point dans l'hémisphère Nord (hors équateur et pôle) de la grille selon l'invention, tandis que la figure 8b correspond au cas d'un codage ou décodage d'un point dans l'hémisphère Sud (hors équateur et pôle). Dans cet exemple on a $N_\phi$ = 122, *id*$_\phi$ = 120, et *sgn*$_\phi$ = 1, *id*$_\theta$ = 3, *index* = 65517 à la figure 8a et *sgn*$_\phi$ = *-1, id*$_\theta$ = 5, *index* = 65529 à la figure 8b. Dans cet exemple, $N_\theta$ (*id*$_\phi$) = 10 et la valeur initiale de *offset*$_{init}$ est :

$$offset_{init} = N_\theta(0) + 2Arr_{id_\phi}\left(\frac{N'_{tot}}{2}\frac{\sin\left(\left(id_\phi + \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)}\right)$$

ce qui donne dans cet exemple : *offset*$_{init}$ = 65534.

A la figure 8a, le décodage de *index* = 65517 donne lieu à correction suivante :
Si *index* ≥ *offset*$_{init}$, *id*$_\phi$ ← *id*$_\phi$ + 1, *offset* ← *offset*$_{init}$ sinon :

$$offset \leftarrow offset_{init} - N_\theta\left(id_\phi\right)$$

Si *index* ≥ *offset*: *sgn_φ* ← -1
Sinon : *offset* ← *offset* - *N_θ*(*id_φ*)

Ce qui conduit à corriger la valeur de *offset* par *offset* ← *offset_init* - 2*N_θ*(*id_φ*) et donne *offset* = 65514.

A la figure 8b, le décodage de *index* = 65529 donne lieu à correction suivante :

Si *index* ≥ *offset_init*, *id_φ* ← *id_φ* + 1, *offset* ← *offset_init*, sinon :

$$offset \leftarrow offset_{init} - N_\theta\big(id_\phi\big)$$

Si *index* ≥ *offset*: *sgn_φ* ← -1
Sinon : *offset* ← *offset* - *N_θ*(*id_φ*)

Ce qui conduit à corriger la valeur de *offset* par *offset* ← *offset_init* - *N_θ*(*id_φ*) et donne *offset* = 65524.

Dans des variantes, la valeur de *offset_init* pourra correspondre à la cardinalité cumulative jusqu'à la couche d'élévation inférieure, ou elle pourra être obtenue par une somme directe à partir des valeurs *N_θ*(i) selon l'invention.

Dans des variantes où la cardinalité cumulative est définie de façon différente, avec des valeurs *N_θ*(i) correspondantes, on adaptera la définition analytique de l'estimation initiale de *offset_init*.

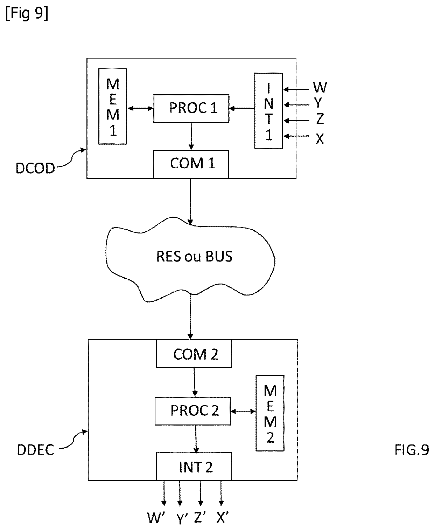

On a illustré sur la **figure 9,** un dispositif de codage DCOD, au sens de l'invention, et un dispositif de décodage DDEC, ces dispositifs étant duals l'un de l'autre (dans le sens de « réversibles ») et reliés l'un à l'autre par un réseau de communication RES ou un bus interne BUS dans un terminal (pour communiquer entre un module d'analyse MASA et un codec de type IVAS ou un autre traitement).

Le dispositif de codage DCOD comporte un circuit de traitement incluant typiquement :

- une mémoire MEM1 pour stocker des données d'instructions d'un programme informatique au sens de l'invention (ces instructions pouvant être réparties entre le codeur DCOD et le décodeur DDEC) ;
- une interface INT1 de réception d'un signal multicanal d'origine **B,** par exemple un signal réparti sur différents canaux ou une version paramétrique en compression avec des paramètres de direction de source au sens de l'invention ;
- un processeur PROC1 pour recevoir ce signal et le traiter en exécutant les instructions de programme informatique que stocke la mémoire MEM1, en vue de son codage ; et
- une interface de communication COM 1 pour transmettre les signaux codés via le réseau ou un bus interne d'un terminal.

Le dispositif de décodage DDEC comporte un circuit de traitement propre, incluant typiquement :

- une mémoire MEM2 pour stocker des données d'instructions d'un programme informatique (ces instructions pouvant être réparties entre le codeur DCOD et le décodeur DDEC comme indiqué précédemment) ;
- une interface COM2 pour recevoir du réseau RES ou d'un bus interne BUS les signaux codés en vue de leur décodage en compression ;
- un processeur PROC2 pour traiter ces signaux en exécutant les instructions de programme informatique que stocke la mémoire MEM2, en vue de leur décodage ; et
- une interface de sortie INT2 pour délivrer des paramètres de directions de source. Bien entendu, cette figure 9 illustre un exemple d'une réalisation structurelle d'un codec (codeur ou décodeur) au sens de l'invention. Les figures 5 à 8 commentées ci-dessus décrivent en détails des réalisations plutôt fonctionnelles de ces codecs.

**Revendications**

1. Procédé de codage d'une direction spatiale d'une source sonore, cette direction étant défini par des coordonnées sphériques comprenant une coordonnée d'élévation et une coordonnée d'azimut, dans lequel un dictionnaire de quantification sphérique est défini sur une sphère 3D par un codage de l'élévation et de l'azimut, et dans lequel :

   - le codage de l'élévation utilise une quantification scalaire, donnant au moins un indice d'élévation codée (i) sur un nombre de niveau (*N_φ*) d'élévation ,
   - le codage de l'azimut utilise une quantification scalaire, en fonction d'un nombre de points par niveau (*N_θ*(i)) dépendant de l'indice de l'élévation codée (i),
   - le nombre de points par niveau (*N_θ*(i)) est déterminé en fonction de deux valeurs de cardinalité cumulative successives (*cumN*(i), *cumN*(i - 1)),

- la valeur de cardinalité cumulative (*cumN(i)*) pour un indice d'élévation codée (i) étant représentative d'un nombre de points proportionnel à un nombre total de points et selon l'aire d'une zone sphérique comprenant au moins une zone délimitée par le plan horizontal supérieur ( $\phi = (i + \frac{1}{2})\delta_\phi$ ) du niveau d'élévation positive de l'indice d'élévation codée (i) et un plan horizontal inférieur de la sphère et **caractérisé en ce qu'**un nombre de points pour le codage de l'azimut est donné pour le niveau d'élévation correspondant à l'équateur et pour le niveau d'élévation correspondant à chacun des pôles de la sphère 3D, le nombre total de points étant obtenu en soustrayant à un nombre de points cible correspondant à un budget de bits donné, ce nombre de points donné correspondant à l'équateur et chacun des pôles de la sphère.

2.  Procédé selon la revendication 1, dans lequel le nombre total de points ( $N'_{tot}$ ) est obtenu en soustrayant à un nombre de points cible ($N_{tot} = 2^{16}$) le nombre de points donné correspondant à l'équateur et chacun des pôles nord et sud de la sphère selon l'expression suivante: $N'_{tot} = N_{tot} - N_\theta(0) - 2N_\theta\left(N_\phi - 1\right)$ ,

    $N_{tot}$ étant le nombre de points cible de la sphère pour un budget de bits donné,
    $N_\theta(0)$, le nombre de points prédéterminé pour le niveau d'élévation correspondant à l'équateur ; et
    $2N_\theta(N_\phi$ - *1)* le nombre de points prédéterminé pour les pôles nord et sud de la sphère.

3.  Procédé selon la revendication 2, dans lequel la valeur de cardinalité cumulative *(cumN(i))* pour un indice d'élévation codée (i) est représentative d'un nombre de points proportionnel au nombre total de points selon l'aire ($A_i$) d'une zone sphérique délimitée par le plan horizontal supérieur ( $\phi = (i + \frac{1}{2})\delta_\phi$ ) du niveau d'élévation positive de l'indice d'élévation codée (i) et ce même plan de la sphère symétrique par rapport à l'équateur ( $\phi = -(i + \frac{1}{2})\delta_\phi$ ) auquel on retranche l'aire ($A_0$) correspondant au niveau d'élévation de l'équateur, selon le rapport suivant:

$$\frac{(A_i - A_0)}{\left(A_{N_\phi - 2} - A_0\right)} N_{tot}{}'$$

$N_\phi$ - 2 étant le nombre de niveaux de quantification de l'élévation sans l'équateur et les pôles nord et sud de la sphère et $A_{N_\phi}$-2, l'aire de la zone sphérique correspondant à un indice d'élévation $N_\phi$ - *2.*

4.  Procédé selon la revendication 3,

    dans lequel l'expression de la valeur de cardinalité cumulative est la suivante :

$$cumN(i) = 2Arr_i \left( \frac{N'_{tot}}{2} \frac{\sin\left((i + \frac{1}{2})\delta_\phi\right) - \sin\left(\frac{\delta_\phi}{2}\right)}{\sin\left((N_\phi - \frac{1}{2})\delta_\phi\right) - \sin\left(\frac{\delta_\phi}{2}\right)} \right)$$

    avec
    $i$ = 1, ..., $N_\phi$ - *2, $N_\phi$* - 2 étant le nombre de niveaux de quantification de l'élévation sans l'équateur et les pôles nord et sud de la sphère,

    *Arr<sub>i</sub>*() étant un arrondi à l'entier le plus proche dépendant de *i*, $2Arr_i\left(\frac{x}{2}\right)$ correspondant à un arrondi à un entier pair et $\delta_\phi$ un pas de quantification de l'élévation donné.

5.  Procédé selon l'une des revendications précédentes, dans lequel le codage de l'élévation donne un indice d'élévation codée (i) sur un nombre de niveau ($N_\phi$) d'élévation et une information de signe.

6.  Procédé selon l'une des revendications précédentes, dans lequel un indice de quantification global à transmettre *(index)* est déterminé en fonction d'un indice d'azimut codé par quantification scalaire sur un nombre de points par

niveau ($N_\theta(i)$) déterminé et d'une valeur de cardinalité cumulative obtenue en fonction au moins de l'indice d'élévation codé.

**7.** Dispositif de codage comportant un circuit de traitement pour la mise en œuvre des étapes du procédé de codage selon l'une des revendications 1 à 6.

**8.** Support de stockage, lisible par un processeur, mémorisant un programme informatique comportant des instructions pour l'exécution du procédé de codage selon l'une des revendications 1 à 6.

**Patentansprüche**

**1.** Verfahren zur Codierung einer räumlichen Richtung einer Schallquelle, wobei diese Richtung durch sphärische Koordinaten definiert wird, die eine Elevationskoordinate und eine Azimutkoordinate umfassen, wobei ein Codebuch zur sphärischen Quantisierung auf einer 3D-Kugel durch eine Codierung der Elevation und des Azimuts definiert wird, und wobei:

- die Codierung der Elevation eine skalare Quantisierung verwendet, die mindestens einen Index codierter Elevation (i) über eine Anzahl von Elevationsniveaus ($N_\phi$) ergibt,
- die Codierung des Azimuts eine skalare Quantisierung in Abhängigkeit von einer Anzahl von Punkten je Niveau ($N_\theta(i)$) verwendet, die von dem Index der codierten Elevation (i) abhängt,
- die Anzahl von Punkten je Niveau ($N_\theta(i)$) in Abhängigkeit von zwei aufeinanderfolgenden Werten kumulativer Kardinalität ($cumN(i), cumN(i\text{ -}1)$) bestimmt wird,
- der Wert kumulativer Kardinalität ($cumN(i)$) für einen Index codierter Elevation (i) für eine Anzahl von Punkten repräsentativ ist, die proportional zu einer Gesamtzahl von Punkten ist, und gemäß der Fläche einer sphärischen Zone, die mindestens eine Zone umfasst, die durch die obere horizontale Ebene ( $\phi = (i + \frac{1}{2})\delta_\phi$ ) des Niveaus positiver Elevation des Index codierter Elevation (i) und eine untere horizontale Ebene der Kugel begrenzt wird, und

**dadurch gekennzeichnet, dass** eine Anzahl von Punkten für die Codierung des Azimuts für das Elevationsniveau, das dem Äquator entspricht, und für das Elevationsniveau, das jedem der Pole der 3D-Kugel entspricht, gegeben wird, wobei die Gesamtzahl von Punkten erhalten wird, indem von einer Zielanzahl von Punkten, die einem gegebenen Bitbudget entspricht, diese gegebene Anzahl von Punkten, die dem Äquator und jedem der Pole der Kugel entspricht, subtrahiert wird.

**2.** Verfahren nach Anspruch 1, wobei die Gesamtzahl von Punkten ( $N'_{tot}$ ) erhalten wird, indem von einer Zielanzahl von Punkten ( $N_{tot} = 2^{16}$ ) die gegebene Anzahl von Punkten, die dem Äquator und jedem der Nord- und Südpole der Kugel entspricht, gemäß dem folgenden Ausdruck subtrahiert wird:

$$N'_{tot} = N_{tot} - N_\theta(0) - 2N_\theta(N_\phi - 1)$$,

wobei $N_{tot}$ die Zielanzahl von Punkten der Kugel für ein gegebenes Bitbudget ist,
$N_\theta(0)$ die vorbestimmte Anzahl von Punkten für das Elevationsniveau ist, das dem Äquator entspricht; und
$2N_\theta(N_\phi \text{ -} 1)$ die vorbestimmte Anzahl von Punkten für den Nord- und den Südpol der Kugel ist.

**3.** Verfahren nach Anspruch 2, wobei der Wert kumulativer Kardinalität *(cumN(i))* für einen Index codierter Elevation (i) repräsentativ für eine Anzahl von Punkten ist, die proportional zur Gesamtzahl von Punkten gemäß der Fläche ($A_i$) einer sphärischen Zone ist, die durch die obere horizontale Ebene ( $\phi = (i + \frac{1}{2})\delta_\phi$ ) des Niveaus positiver Elevation des Index codierter Elevation (i) und diese selbe Ebene der Kugel, die symmetrisch zu dem Äquator ( $\phi = -(i + \frac{1}{2})\delta_\phi$ ) ist, begrenzt wird, von der man die Fläche ($A_0$) abzieht, die dem Elevationsniveau des Äquators entspricht, gemäß dem folgenden Verhältnis:

$$\frac{(A_i - A_0)}{\left(A_{N_\phi - 2} - A_0\right)} N'_{tot}$$

$N_\phi$ - 2 wobei die Anzahl von Quantisierungsniveaus der Elevation ohne den Äquator und den Nord- und Südpol der Kugel ist und $A_{N_\phi-2}$ die Fläche der sphärischen Zone ist, die einem Elevationsindex $N_\phi$ - 2 entspricht.

4. Verfahren nach Anspruch 3, wobei der Ausdruck des Werts kumulativer Kardinalität der folgende ist:

$$cumN(i) = 2Arr_i\left(\frac{N'_{tot}}{2} \frac{\sin\left(\left(i + \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)}\right)$$

worin

$i$ = 1, ... ,$N_\phi$ - 2, $N_\phi$ - 2 die Anzahl von Quantisierungsniveaus der Elevation ohne den Äquator und den Nord- und Südpol der Kugel ist,

$Arr_i()$ eine Rundung auf die nächste ganze Zahl ist, die von $i$ abhängt, $2Arr_i\left(\frac{x}{2}\right)$ eine Rundung auf eine gerade ganze Zahl ist und $\delta_\phi$ ein gegebener Quantisierungsschritt der Elevation ist.

5. Verfahren nach einem der vorhergehenden Ansprüche, wobei die Codierung der Elevation einen Index codierter Elevation (i) über eine Anzahl von Elevationsniveaus ($N_\phi$) und eine Vorzeicheninformationen ergibt.

6. Verfahren nach einem der vorhergehenden Ansprüche, wobei ein zu übertragender globaler Quantisierungsindex (*Index*) in Abhängigkeit von einem durch skalare Quantisierung codierten Azimutindex über eine Anzahl von Punkten je Niveau ($N_\theta(i)$) und von einem Wert kumulativer Kardinalität, der in Abhängigkeit mindestens von dem codierten Elevationsindex erhalten wird, bestimmt wird.

7. Vorrichtung zur Codierung, umfassend eine Verarbeitungsschaltung zur Umsetzung der Schritte des Verfahrens zur Codierung nach einem der Ansprüche 1 bis 6.

8. Von einem Prozessor lesbares Speichermedium, das ein Computerprogramm speichert, das Anweisungen zur Ausführung des Verfahrens zur Codierung nach einem der Ansprüche 1 bis 6.

**Claims**

1. Method for coding a spatial direction of a sound source, this direction being defined by spherical coordinates comprising an elevation coordinate and an azimuth coordinate, wherein a spherical quantization dictionary is defined on a 3D sphere by an elevation coding and an azimuth coding, and wherein:

   - the elevation coding uses a scalar quantization, giving at least one coded elevation index (i) on a number of elevation levels ($N_\phi$);
   - the azimuth coding uses a scalar quantization, according to a number of points per level ($N_\theta(i)$) depending on the coded elevation index (i);
   - the number of points per level ($N_\theta(i)$) is determined on the basis of two successive cumulative cardinality values (*cumN(i),cumN(i* - 1));
   - the cumulative cardinality value *(cumN(i))* for a coded elevation index (i)being representative of a number of points proportional to a total number of points and according to the area of a spherical zone comprising at least one zone delimited by the upper horizontal plane ( $\phi = \left(i + \frac{1}{2}\right)\delta_\phi$ ) of the positive elevation level of the coded elevation index (i) and a lower horizontal plane of the sphere ; and

   **characterised in that** a number of points for the azimuth coding is provided for the elevation level corresponding to the equator and for the elevation level corresponding to each of the poles of the 3D sphere, the total number of points is obtained by subtracting from a target number of points corresponding to a given bit budget, this given number of points corresponding to the equator and each of the poles of the sphere.

2. Method according to Claim 1, wherein the total number of points ( $N'_{tot}$ ) is obtained by subtracting, from a target number of points ($N_{tot} = 2^{16}$), the predetermined number of points corresponding to the equator and each of the North and South poles of the sphere according to the following expression:

$$N'_{tot} = N_{tot} - N_\theta(0) - 2N_\theta\big(N_\phi - 1\big)$$ ,

$N_{tot}$ being the target number of points of the sphere for a given bit budget;
$N_\theta(0)$, being the predetermined number of points for the elevation level corresponding to the equator; and
$2N_\theta(N_\phi - 1)$, being the predetermined number of points for the North and South poles of the sphere.

3. Method according to Claim 2, wherein the cumulative cardinality value *(cumN(i))* for a coded elevation index (i) is representative of a number of points proportional to the total number of points according to the area ($A_i$) of a spherical zone delimited by the upper horizontal plane ( $\phi = (i + \frac{1}{2})\delta_\phi$ ) of the positive elevation level of the coded elevation index (i) and this same plane of the sphere symmetrical with respect to the equator ( $\phi = -(i + \frac{1}{2})\delta_\phi$ ) minus the area ($A_0$) corresponding to the elevation level of the equator, according to the following ratio:

$$\frac{(A_i - A_0)}{\big(A_{N_\phi - 2} - A_0\big)}N_{tot}{}'$$

$N_\phi$ - 2 being the number of elevation quantization levels without the equator and the North and South poles of the sphere and $A_{N_\phi-2}$, the area of the spherical zone corresponding to an elevation index $N_\phi$ - 2.

4. Method according to Claim 3, wherein the expression for the cumulative cardinality value is as follows:

$$cumN(i) = 2Arr_i\left(\frac{N'_{tot}}{2}\frac{\sin\left((i + \frac{1}{2})\delta_\phi\right) - \sin\left(\frac{\delta_\phi}{2}\right)}{\sin\left((N_\phi - \frac{1}{2})\delta_\phi\right) - \sin\left(\frac{\delta_\phi}{2}\right)}\right)$$

with

$i = 1, ... , N_\phi$ - 2, $N_\phi$ - 2 being the number of elevation quantization levels without the equator and the North and South poles of the sphere,

*$Arr_i$()* being a rounding to the nearest integer depending on *i*, $2Arr_i\left(\frac{x}{2}\right)$ corresponding to a rounding to an even integer and $\delta_\phi$ being a given quantization step of the elevation.

5. Method according to any of the preceding claims, wherein the elevation coding gives a coded elevation index (i) on a number of elevation levels ($N_\phi$) and sign information.

6. Method according to any of the preceding claims, wherein a global quantization index to be transmitted (*index*) is determined based on an azimuth index coded by scalar quantization on a determined number of points per level ($N_\phi(i)$) and a cumulative cardinality value obtained based on at least the coded elevation index.

7. Coding device comprising a processing circuit for implementing the steps of the coding method according to any of Claims 1 to 6.

8. Processor-readable storage medium storing a computer program comprising instructions for executing the coding method according to any of Claims 1 to 6.

[Fig 1]

FIG.1 (état de l'art)

[Fig 2]

FIG.2 (état de l'art)

[Fig 3]

FIG.3 (état de l'art)

[Fig 4]

FIG.4 (état de l'art)

[Fig 5a]

FIG.5a

[Fig 5b]

FIG.5b

[Fig 6a]

FIG.6a

[Fig 6b]

FIG.6b

[Fig 7a]

FIG.7a

[Fig 7b]

FIG.7b

[Fig 8a]

$$offset_{init} = N_\theta(0) + 2Arr_{id_\phi}\left(\frac{N'_{tot}}{2}\frac{\sin\left(\left(id_\phi + \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)}\right)$$

FIG.8a

[Fig 8b]

$$offset_{init} = N_\theta(0) + 2Arr_{id_\phi}\left(\frac{N'_{tot}}{2}\frac{\sin\left(\left(id_\phi + \frac{1}{2}\right)\delta_\phi\right) - \sin\left(\frac{\delta_\phi}{2}\right)}{\sin\left(\left(N_\phi - \frac{1}{2}\right)\delta_\phi\right) - \sin\left(\frac{\delta_\phi}{2}\right)}\right)$$

FIG.8b

[Fig 9]

FIG.9

EP 4 479 967 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2021019126 A1

- WO 2020016479 A1

**Littérature non-brevet citée dans la description**

- **ATSCHKAL B et al.** Spherical Logarithmic Quantization. *IEEE TRANSACTIONS ON AUDIO, SPEECH AND LANGUAGE PROCESSING*, 02 June 2009
- **V. PULKKI**. Spatial sound reproduction with directional audio coding. *Journal of the Audio Engineering Society*, 2007, vol. 55 (6), 503-516

- **NOKIA CORPORATION**. On IVAS audio formats for mobile capture devices.. *3GPP Tdoc S4-180087*
- **NOKIA CORPORATION**. IVAS MASA C Reference Software. *3GPP Tdoc S4-191167*, October 2019